# EUROPÄISCHE PATENTANMELDUNG

(11) **EP 4 794 352 A1**
(43) Veröffentlichungstag der Anmeldung: **19.08.2026**
(21) Anmeldenummer: 26152505.9
(22) Anmeldetag: 19.01.2026
(51) Int. Cl.: H04R 1/1025, H02J 7/04, H02J 7/94

(54) **VERFAHREN ZUM LADEN EINES WIEDERAUFLADBAREN ENERGIESPEICHERS**

(30) Priorität: 11.02.2025 DE 102025105032
(71) Anmelder: Sivantos Pte. Ltd., Singapore 539775 (SG)
(72) Erfinder: TOO, Kim Hui, 539775 Singapur (SG); CHOE, Kin Khan, 539775 Singapur (SG); YAP, Heng Goh, 539775 Singapur (SG)
(74) Vertreter: FDST Patentanwälte

(57) **Zusammenfassung**

Die Erfindung betrifft ein Verfahren zum Laden eines wiederaufladbaren Energiespeichers (23) eines elektronischen Geräts (6) über eine Ladeschnittstelle (14), wobei zu Beginn eines Ladevorgangs eine hinterlegte Ladespannung (V_{CI}) an die Ladeschnittstelle (14) angelegt wird, wobei während eines Ladevorgangs ein durch die Ladeschnittstelle (14) fließender Ladestrom (I_{CI}) erfasst wird, wobei anhand des erfassten Ladestroms (I_{CI}) ein aktueller Ladezustand (ODBR, FAST, NORM, TERM) des Energiespeichers (23) bestimmt wird, wobei für den bestimmten Ladezustand (ODBR, FAST, NORM, TERM) ein Spannungsniveau (V_{CI, FAST,} V_{CI, NORM,} V_{CI, ODBR,} V_{CI, TERM}) für die Ladespannung (V_{CI}) bestimmt wird, und wobei die Ladespannung (V_{CI}) auf das bestimmte Spannungsniveau (V_{CI}, _{FAST}, V_{CI, NORM,} V_{CI, ODBR,} V_{CI, TERM}) eingestellt wird.

## Beschreibung

Die Erfindung betrifft ein Verfahren zum Laden eines wiederaufladbaren Energiespeichers eines elektronischen Geräts über eine Ladeschnittstelle. Die Erfindung betrifft weiterhin ein Ladegerät zur Durchführung des Verfahrens sowie ein Ladesystem mit einem solchen Ladegerät.

Als Hörgerät wird allgemein ein elektronisches Gerät bezeichnet, dass das Hörvermögen einer das Hörgerät tragenden Person unterstützt. Insbesondere bezieht sich die Erfindung auf ein Hörgerät, das dazu eingerichtet ist, einen Hörverlust eines hörgeschädigten Nutzers ganz oder teilweise zu kompensieren. Ein solches Hörgerät wird auch als "Hörhilfegerät" (engl.: Hearing Aid, HA) bezeichnet. Daneben gibt es Hörgeräte, die das Hörvermögen von normalhörenden Nutzern schützen oder verbessern, zum Beispiel in komplexen Hörsituationen ein verbessertes Sprachverständnis ermöglichen sollen. Solche Geräte werden auch als "Personal Sound Amplification Products" (kurz: PSAP) bezeichnet. Schließlich fallen unter den Begriff "Hörgerät" in dem hier verwendeten Sinn auch auf oder in dem Ohr getragene Kopfhörer (drahtgebunden oder drahtlos sowie mit oder ohne aktiver Störschallunterdrückung), Headsets, etc. sowie implantierbare Hörgeräte, wie beispielsweise Cochlea-Implantate. Ein Hörgerät kann auch Teil eines AR-Systems (AR: Augmented Reality) oder VR-Systems (VR: Virtual Reality) sein, um die akustischen Informationen einer virtuellen Schallquelle an den Benutzer auszugeben.

Hörgeräte im Allgemeinen, und Hörhilfegeräte im Speziellen, sind meist dazu ausgebildet, am Kopf und hier insbesondere in oder an einem Ohr des Nutzers getragen zu werden, insbesondere als Hinter-dem-Ohr-Geräte (engl.: behind the ear, BTE) oder In-dem-Ohr-Geräte (engl.: in the ear, ITE). Im Hinblick auf ihre in-terne Struktur weisen Hörgeräte regelmäßig mindestens einen Ausgangswandler auf, der ein zum Zweck der Ausgabe zugeführtes Ausgangs-Audiosignal in ein für den Nutzer als Schall wahrnehmbares Signal umwandelt, und letzteres an den Nutzer ausgibt.

In den meisten Fällen ist der Ausgangswandler als elektro-akustischer Wandler ausgebildet, der das (elektrische) Ausgangs-Audiosignal in einen Luftschall umwandelt, wobei dieser ausgegebene Luftschall in den Gehörgang des Nutzers abgegeben wird. Bei einem hinter dem Ohr getragenen Hörgerät ist der auch als "Hörer" ("Receiver") bezeichnete Ausgangswandler meist außerhalb des Ohrs in einem Gehäuse des Hörgeräts integriert. Der von dem Ausgangswandler ausgegebene Schall wird in diesem Fall mittels eines Schallschlauchs in den Gehörgang des Nutzers geleitet. Alternativ hierzu kann der Ausgangswandler auch in dem Gehörgang, und somit außerhalb des hinter dem Ohr getragenen Gehäuses, angeordnet sein. Solche Hörgeräte werden nach der englischen Bezeichnung "Receiver In Channel" auch als RIC-Geräte bezeichnet. Im Ohr getragene Hörgeräte, welche so klein dimensioniert sind, dass sie nach außen über den Gehörgang nicht hinausstehen, werden (nach dem englischen Begriff "Completely in Canal") auch als CIC-Geräte bezeichnet.

In weiteren Bauformen kann der Ausgangswandler auch als elektro-mechanischer Wandler ausgebildet sein, der das Ausgangs-Audiosignal in Körperschall (Vibrationen) umwandelt, wobei dieser Körperschall zum Beispiel in den Schädelknochen des Nutzers abgegeben wird. Ferner gibt es implantierbare Hörgeräte, insbesondere Cochlear-Implantate, und Hörgeräte, deren Ausgangs-wandler den Hörnerv des Nutzers direkt stimulieren.

Zusätzlich zu dem Ausgangswandler weist ein Hörgerät häufig mindestens einen (akusto-elektrischen) Eingangswandler auf. Im Betrieb des Hörgeräts nimmt der oder jeder Eingangswandler einen Luftschall aus der Umgebung des Hörgeräts auf, und wandelt diesen Luftschall in ein Eingangs-Audiosignal (d.h. ein elektrisches Signal, das eine Information über den Umgebungsschall transportiert) um.

Dieses - auch als "aufgenommenes Schallsignal" bezeichnete - Eingangs-Audiosignal wird regelmäßig in ursprünglicher oder verarbeiteter Form an den Nutzer selbst ausgegeben, z.B. zur Realisierung eines sogenannten Transparenzmodus bei einem Kopfhörer, zur aktiven Störschallunterdrückung oder - z.B. bei einem Hörhilfegerät - zur Erzielung einer verbesserten Geräuschwahrnehmung des Nutzers.

Zudem weist ein Hörgerät häufig eine Signalverarbeitungseinheit (Signalprozessor) auf. In der Signalverarbeitungseinheit wird das oder jedes Eingangs-Audiosignal verarbeitet (d. h. hinsichtlich seiner Schallinformation modifiziert). Die Signalverarbeitungseinheit gibt dabei ein entsprechend verarbeitetes Audiosignal (auch als "Ausgangs-Audiosignal" oder "modifiziertes Schallsignal" bezeichnet) an den Ausgangswandler und/oder an ein externes Gerät aus.

Hörgeräte werden in der Regel mit Batterien als geräteinterne Energiespeicher betrieben. Die Betriebsdauer ist je nach Energiegehalt (Energieladung) der Batterien und den Anforderungen des Hörgeräts (insbesondere dessen Energieverbrauchs) begrenzt. In Anbetracht des allgemeinen Trends zur Miniaturisierung werden Batterien mit geringer Größe bevorzugt, was ihren Energiegehalt zusätzlich begrenzt. Um den häufigen Austausch verbrauchter Batterien zu vermeiden, können Hörgeräte mit wiederaufladbaren Batterien (Akkumulatoren) wie Nickel-Metallhydrid-(NiMH) oder Lithium-Ionen- (Li-Ion) Batterien betrieben werden.

Hörgeräte, die mit wieder aufladbaren Batterien betrieben werden, weisen häufig Anschlüsse auf, um eine elektrische Kontaktierung mit einem Ladegerät herzustellen, und somit beim Aufladen der wieder aufladbaren Batterien diese innerhalb des Hörgeräts belassen zu können. Bei einem (Auf-)Ladeprozess ist eine möglichst hohe Ladeffizienz gewünscht, um eine Wärmeentwicklung während des Ladevorgangs zu reduzieren, ein kompakteres tragbares Ladegerät bereitzustellen, und die Anzahl der Ladevorgänge, welche ein insbesondere tragbares Ladegerät bereitstellen kann zu erhöhen.

Eine verbesserte Ladeffizienz kann beispielsweise dadurch erreicht werden, dass gerade ausreichend Ladestrom zugeführt wird, um den Energiespeicher des Geräts zu laden, während gleichzeitig die Verlustleistung minimiert wird.

Bei einem herkömmlichen Ladeverfahren wird beispielsweise eine konstante Ladespannung, beispielsweise 5 V (Volt), an einen Ladeeingang eines Ladereglers des zu ladenden Geräts angelegt. Der Laderegler arbeitet hierbei in einem Konstantstrommodus und liefert einen voreingestellten konstanten Ladestrom an den Energiespeicher. Aus Sicht des Ladegeräts wird ein etwas höherer Ladestrom als der Batterieladestrom bezogen, wobei der zusätzliche Stromanteil für die internen Vorgänge des Ladereglers während des Ladevorgangs verwendet wird. Mit fortschreitendem Ladevorgang steigt die Batteriespannung allmählich an, da der konstante Ladestrom in die Batterie fließt und sich die Ladung ansammelt. Wenn die Ladespannung des Ladegeräts deutlich höher ist als die Batteriespannung des Energiespeichers, insbesondere zu Beginn des Ladevorgangs, übersteigt die gesamte Ladeleistung die kombinierte Leistung, welche für das Laden der Batterie und den Betrieb des Ladereglers erforderlich ist. Die Differenz zwischen der gesamten Ladeleistung und der Leistung, welche für das Laden der Batterie und den Betrieb des Ladereglers verwendet wird, stellt eine übermäßige Leistung dar, welche im Wesentlichen eine Verlustleistung ist, die häufig als Wärme im Laderegler abgeführt wird, anstatt direkt zum Laden des Energiespeichers verwendet zu werden.

Aus der US 2024/0204570 A1 ist ein Verfahren zum Laden eines wiederaufladbaren Energiespeichers eines elektronischen Geräts bekannt, bei welchem eine erhöhte Ladeffizienz realisiert wird. Hierzu wird die in das Gerät eingespeiste Ladespannung kontinuierlich an die Batteriespannung plus einen Offset angepasst. Dadurch wird die Ladeleistung gerade so hochgehalten, dass der Energiespeicher geladen wird, während überschüssige Leistung minimiert wird. Die Umsetzung dieses Verfahrens erfordert jedoch einen Kommunikationsmechanismus zwischen dem Ladegerät und dem zu ladenden Gerät, wie z. B. Lastmodulation oder drahtlose Kommunikation, um die Batteriespannungsinformationen an das Ladegerät zu übermitteln. Das Ladegerät demoduliert beispielsweise das empfangene Signal, decodiert die Batteriespannungsinformationen und passt anschließend die Ladespannung entsprechend an. Ein solches kontinuierliches variieren der Ladespannung ermöglicht es die Wärmeabgabe des Ladereglers zu reduzieren.

Nachteiligerweise verfügen lediglich etwa über 50 % der auf dem Markt erhältlichen Unterhaltungs- und Hörgeräteelektroniken über keine Kommunikationsfunktion zwischen Gerät und Ladegerät, insbesondere bei Kontaktladeszenarien. Das Fehlen von Batteriespannungsinformationen am Ladegerät schränkt die Umsetzung der kontinuierlich variierenden Ladespannung für die meisten elektronischen Geräte ein, was zu einer allgemein geringen Ladeeffizienz dieser Geräte führt.

Der Erfindung liegt die Aufgabe zugrunde, ein besonders geeignetes Verfahren zum Laden eines wiederaufladbaren Energiespeichers eines elektronischen Geräts über eine Ladeschnittstelle anzugeben. Insbesondere soll ein Ladeverfahren angegeben werden, welches eine möglichst hohe Ladeeffizienz realisiert, ohne die Notwendigkeit einer Kommunikationsverbindung zu dem elektronischen Gerät. Der Erfindung liegt weiterhin die Aufgabe zugrunde, ein besonders geeignetes Ladegerät sowie ein besonders geeignetes Ladesystem anzugeben.

Hinsichtlich des Verfahrens wird die Aufgabe mit den Merkmalen des Anspruchs 1 und hinsichtlich des Ladegeräts 5 sowie hinsichtlich des Ladesystems mit den Merkmalen des Anspruchs 8 erfindungsgemäß gelöst. Vorteilhafte Ausgestaltungen und Weiterbildungen sind Gegenstand der abhängigen Ansprüche (Unteransprüche). Die im Hinblick auf das Verfahren angeführten Vorteile und Ausgestaltungen sind sinngemäß auch auf das Ladegerät und/oder das Ladesystem übertragbar und umgekehrt.

Die Konjunktion "und/oder" ist hier und im Folgenden derart zu verstehen, dass die mittels dieser Konjunktion verknüpften Merkmale sowohl gemeinsam als auch als Alternativen zueinander ausgebildet sein können.

Sofern nachfolgend Verfahrensschritte beschrieben werden, ergeben sich vorteilhafte Ausgestaltungen für das Ladegerät und/oder das Ladesystem insbesondere dadurch, dass dieses ausgebildet ist, einen oder mehrere dieser Verfahrensschritte auszuführen.

Das erfindungsgemäße Verfahren ist zum Laden eines wiederaufladbaren Energiespeichers eines elektronischen Geräts über eine Ladeschnittstelle vorgesehen sowie dafür geeignet und eingerichtet. Das Verfahren wird insbesondere von einem Ladegerät für das elektronische Gerät durchgeführt.

Unter einem "Laden eines Energiespeichers" wird hier und im Folgenden insbesondere das (Auf-)Laden eines solchen Energiespeichers mit elektrischer Energie verstanden.

Unter einem "wiederaufladbaren Energiespeicher" ist hier und im Folgenden insbesondere eine sekundäre Batterie des elektronischen Geräts zu verstehen, bei welcher eine verbrauchte Energie mittels eines elektrischen (Auf-)Ladevorgangs wiederherstellbar ist. Der Energiespeicher ist hierbei beispielsweise als eine elektrochemische Batterie, insbesondere ein Akkumulator, beispielsweise als ein Lithium-lonen-Akkumulator, ausgeführt.

Die Ladeschnittstelle ist insbesondere als ein Ladekontakt oder Ladeanschluss (Ladepin, Ladestecker, Ladebuchse) ausgeführt, so dass im Zuge des Verfahrens eine galvanische Kopplung zum elektronischen Gerät realisiert ist. Mit anderen Worten weist das elektronische Gerät eine komplementäre (Gegen-)Ladeschnittstelle auf, welche mit der Ladeschnittstelle verbunden wird, um die Ladeenergie in das Gerät beziehungsweise in den Energiespeicher einzuspeisen. Mit anderen Worten erfolgt das Laden des Energiespeichers als ein Kontaktladen oder Kontaktladeszenario. Vorzugsweise weist das elektronische Gerät hierbei einen Laderegler (Charging Controller) zwischen der Gegenladeschnittstelle und dem Energiespeicher auf, welcher den Ladevorgang geräteseitig überwacht.

Das elektronische Gerät ist beispielsweise eine Unterhaltungs- oder Telekommunikationselektronik, insbesondere ein Hörinstrument. Unter einem Hörinstrument ist hierbei ein Gerät zur Ausgabe eines Audiosignals wie beispielsweise Sprache oder Musik zu verstehen, wie beispielsweise ein Telefon, Smartphone, Headset, Kopfhörer, Ohrhörer, oder Musikabspielgerät. Vorzugsweise ist das Hörinstrument ein Hörhilfegerät, also ein elektronisches Gerät, welches im Betrieb das Gehör des Trägers (Benutzer oder Träger des Hörhilfegeräts) unterstützt. Das Hörhilfegerät ist hierbei speziell dafür ausgelegt, eine Hörbeeinträchtigung eines hörgeschädigten Benutzers zumindest teilweise auszugleichen. Andere Hörinstrument-Typen zielen darauf ab, das Gehör normalhörender Nutzer zu unterstützen, also die Sprachwahrnehmung in komplexen akustischen Situationen zu verbessern.

Verfahrensgemäß wird zu Beginn eines Ladevorgangs eine hinterlegte Ladespannung an die Ladeschnittstelle angelegt. Mit anderen Worten wird eine Ladespannung mit einem definierten (Anfangs-)Spannungsniveau, also eine konstante nominale Ladespannung, erzeugt. Das Spannungsniveau der Ladespannung ist hierbei derart dimensioniert, dass der Laderegler des elektronischen Geräts seine Arbeit aufnimmt.

Anschließend wird während des Ladevorgangs ein durch die Ladeschnittstelle fließender elektrischer Ladestrom erfasst. Hierzu wird die Ladeschnittstelle beispielsweise kontinuierlich von einem Stromsensor überwacht.

Die Erfindung geht von der Erkenntnis aus, dass eine Größe des Ladestroms (Ladestrom-Amplitude beziehungsweise die Stromstärke des Ladestroms) je nach Ladezustand des geräteseitigen Energiespeichers erheblich variiert, so dass der an der Ladeschnittstelle gemessene Ladestrom zur Bestimmung eines aktuellen Ladezustands verwendet werden kann. Aufgrund eines gewissen Stromverbrauchs im Laderegler ist der über die Ladeschnittstelle fließende Ladestrom etwas höher dimensioniert als der mit dem jeweiligen Ladezustand verbundene Ladestrom.

Erfindungsgemäß wird während des Ladevorgangs anhand des erfassten oder gemessenen Ladestroms ein aktueller Ladezustand des Energiespeichers bestimmt. Erfindungsgemäß wird weiterhin anhand des bestimmten Ladezustands ein (Soll-) Spannungsniveau für die Ladespannung bestimmt, und anschließend die Ladespannung auf dieses bestimmte Spannungsniveau eingestellt. Mit anderen Worten wird die Ladespannung derart geändert (angepasst), sie einem für den aktuellen Ladezustand geeigneten Spannungsniveau entspricht. Unter einem "geeigneten Spannungsniveau" ist hierbei eine Ladespannung zu verstehen, welcher über einer Ausgangsspannung des Energiespeichers im aktuellen Ladezustand liegt, um einen unterbrechungsfreien Ladevorgang zu gewährleisten, wenn das Gerät zwischen verschiedenen Ladezuständen wechselt. Dadurch ist ein besonders geeignetes Verfahren zum Laden eines wiederaufladbaren Energiespeichers realisiert.

Durch das erfindungsgemäße Verfahren wird die Ladespannung anhand eines aus dem Ladestrom abgeleiteten Ladezustand des Energiespeichers gesteuert und/oder geregelt, so dass ein geringerer Leistungsverlust und eine verbesserte Ladeeffizienz ermöglicht wird. Insbesondere entfällt hierbei die Notwendigkeit einer Kommunikation mit dem elektronischen Gerät beziehungsweise dessen Ladereglers, da der Ladezustand anhand des gemessenen Ladestroms abgeleitet wird. Dadurch wird ein Design für ein entsprechendes Ladegerät vereinfacht und die Anforderungen an die Verarbeitungsleistung werden reduziert.

Mit anderen Worten wird eine Anpassung der Ladespannung von einem Ladegerät an das Gerät auf Grundlage der Größe des Ladestroms, welcher über die Ladeschnittstelle in das Gerät eingespeist wird, durchgeführt, ohne dass eine Kommunikation zwischen dem Gerät und dem Ladegerät erforderlich ist. Das erfindungsgemäße Verfahren stellt im Wesentlichen eine Weiterentwicklung gegenüber dem in der US 2024/0204570 A1 beschriebenen Ladeverfahren der kontinuierlichen variierenden Ladespannung dar, so dass die Ladeeffizienz für elektronische Geräte verbessert wird, welche nicht über Kommunikationsfähigkeiten mit dem Ladegerät verfügen.

In einer vorteilhaften Weiterbildung wird der aktuelle Ladezustand anhand eines Schwellwertvergleichs des erfassten Ladestroms mit einem hinterlegten Stromschwellwert bestimmt. Mit anderen Worten ist zumindest ein Ladezustand des Energiespeichers anhand eines korrespondierenden Ladestromwerts charakterisiert, und der erfasste Ladestrom mit mindestens einem solchen hinterlegten Ladestromwert verglichen, um den aktuellen Ladezustand des Geräts beziehungsweise des Energiespeichers zu bestimmen.

Vorzugsweise ist beim Schwellwertvergleich ein gewisser Toleranzbereich um den Ladestromwert berücksichtigt. Mit anderen Worten ist dem Ladezustand des Energiespeichers ein Ladestrombereich oder Ladestromintervall zugeordnet, wobei im Zuge des Schwellwertvergleichs geprüft wird, ob sich der erfasste Ladestrom in diesem Bereich oder Intervall befindet, also ob der erfasste Ladestrom größer als eine Untergrenze (Ladestromwert minus Toleranzwert) und kleiner als eine Obergrenze (Ladestromwert plus Toleranzwert) ist.

Der Toleranzwert ist beispielsweise als Prozentsatz des Ladestroms oder als ein absoluter Wert, der einen Bruchteil des Ladestroms darstellt, definiert.

Die Verwendung eines Prozentsatzes wird in der Regel bei hohen Ladeströmen bevorzugt, z. B. bei Schnellladeszenarien. Andererseits wird der absolute Wert im Allgemeinen bei niedrigen Ladeströmen angewendet, wie sie für das normale Laden, die Wiederherstellung nach Tiefentladung und den Ladeabschluss verwendet werden. Der Grund für die Verwendung eines absoluten Werts für niedrige Ladeströme ist, dass die prozentuale Toleranz für niedrige Ladeströme im Vergleich zu hohen Ladeströmen einen engeren Bereich aufweist. Dieser engere Toleranzbereich kann es für das Ladegerät schwierig machen, den aktuellen Ladezustand genau zu bestimmen, insbesondere wenn es geringfügige Unterschiede bei den Ladeströmen zwischen den Geräten gibt.

In einer bevorzugten Ausgestaltung ist eine Anzahl von Stromschwellwerten oder Schwellwertbereichen für unterschiedliche Ladezustände hinterlegt. Mit anderen Worten ist eine diskrete Anzahl von Ladezuständen für den Energiespeicher definiert.

In einer denkbaren Anwendung sind beispielsweise vier Ladezustände für den Energiespeicher definiert und hinterlegt. Die Ladezustände sind hierbei beispielsweise "Überentladungs-Wiederherstellungsladung", "Schnellladung", "Normalladung" und "Ladevorgang beenden".

Die Nachfolgenden Ausführungen beziehen sich insbesondere auf ein als Hörinstrument oder Hörhilfegerät ausgeführtes elektronisches Gerät. Der Energiespeicher ist hierbei beispielsweise eine Lithium-Ionen-Batterie, welche im vollgeladenen Zustand beispielsweise eine Energiespeicher- oder Batteriespannung zwischen 4,2 V bis 4,35 V aufweist. Die Ausführungen sind jedoch sinngemäß auch auf andere elektronische Geräte oder Spannungsbereiche übertragbar.

Der Ladezustand "Überentladungs-Wiederherstellungsladung" (engl.: overdischarged battery recovery, ODBR) tritt auf, wenn die Energiespeicherspannung unter einem normalen Betriebsbereich, beispielsweise unter 3,0 V, liegt. Der ODBR-Ladezustand realisiert hierbei eine Wiederherstellung nach einer Tiefentladung des Energiespeichers. Hierbei ist es beispielsweise denkbar, dass das elektronische Gerät möglicherweise einen niedrigeren Spannungsschwellenwert, z. B. unter 2,5 V, definiert, beispielsweise aufgrund des Vorhandenseins eines Schutzmoduls zwischen dem Energiespeicher und dem Laderegler. In einem solchen Modul öffnet sich zum Beispiel eine parallel zu einem Transistorschalter geschaltete Body-Diode, wenn die Energiespeicherspannung unter einen normalen Betriebsbereich fällt, um eine weitere Entladung zu verhindern. Die Leitung der Body-Diode führt zu einem Spannungsabfall entlang des Energiespeicheranschlusspfads, wodurch der Laderegler erkennt, dass sich der Energiespeicher in einem überentladenen Zustand befindet, und zwar bei einer niedrigeren Spannung als üblich für die Wiederherstellung.

Der Ladezustand "Schnellladung" (engl.: fast charging, FAST) tritt auf, wenn die Energiespeicherspannung innerhalb eines normalen Betriebsbereichs, aber nahe einem unteren Ende liegt, beispielsweise zwischen 3,0 V und 3,9 V. Der FAST-Ladezustand beziehungsweise der Ladevorgang während des FAST-Ladezustandes ist darauf ausgelegt, dass bei einer möglichst kurzen Ladezeit ein möglichst hoher Ladestrom bereitgestellt wird. Dadurch wird innerhalb einer kurzen Ladezeit eine möglichst hohe Nutzungsdauer des elektronischen Geräts ermöglicht. Beispielsweise wird bei einer halben Stunde mit einer Schnelllade-Ladung eine Nutzungsdauer von beispielsweise 6 Stunden realisiert.

Der Ladezustand "Normalladung" (engl.: normal charging, NORM) ist durch eine Energiespeicherspannung charakterisiert, welche höher als der Schwellwert für das Schnellladen ist. Der NORM-Bereich ist beispielsweise zwischen 3,7 V und 4,35 V dimensioniert. Der Ladevorgang in dem NORM-Ladezustand soll die Lebensdauer des Energiespeichers verlängern, indem der Ladestrom reduziert wird, sobald der Energiespeicher für mehrere Betriebsstunden ausreichend aufgeladen ist.

Der Ladezustand "Ladevorgang beenden" (engl.: terminate charging, TERM) ist erreicht, wenn die Energiespeicherspannung nahezu der vollen Ladespezifikation entspricht, beispielsweise wischen 4,2 V und 4,35 V.

Der FAST-Ladezustand weist hierbei den höchsten Ladestrom der vier Ladezustände auf. Darauf folgt der Ladestrom des NORM-Ladezustands, wobei der ODBR-Ladezustand den nächsthöheren Stromwert aufweist. Der TERM-Ladezustand weist den niedrigsten Ladestrom auf.

In einer zweckmäßigen Ausbildung wird die Ladespannung bei einer Änderung des Ladezustands auf das bestimmte Spannungsniveau eingestellt. Dadurch erfolgt die Änderung der Ladespannung insbesondere stufen- oder schrittweise, wenn eine Änderung des Ladezustands, also ein Übergang zwischen zwei definierten oder hinterlegten Ladezuständen, beziehungsweise zwischen zwei hinterlegten Schwellwert(-bereichen), erfasst wird. Bei einer solchen stufenweisen Änderung erfolgen Spannungsanpassungen lediglich bei Ladezustandsübergängen und bleiben ansonsten konstant, während eine kontinuierliche Änderung wie im Stand der Technik eine fortlaufende Überwachung und Anpassung der Ladespannung erfordert, da die Energiespeicherspannung während des Ladevorgangs kontinuierlich ansteigt. Somit erfordert der Ansatz mit stufenweiser Änderung im Vergleich zur Methode mit kontinuierlicher Änderung weniger Rechenleistung an einem Ladegerät. Der reduzierte Rechenaufwand ermöglicht somit den Einsatz eines kostengünstigeren Controllers zur Durchführung des Verfahrens. Weiterhin wird ein Energieverbrauch am Ladegerät während des Ladevorgangs vorteilhaft reduziert. Insbesondere weist das erfindungsgemäße Verfahren somit eine reduzierte Komplexität und eine höhere Zuverlässigkeit als bei einer kontinuierlichen Anpassung der Ladespannung auf.

In dieser Ausbildung wird die Ladespannung somit lediglich als Reaktion auf signifikante Schwankungen des Ladestromflusses hin geändert, ohne dass eine Energiespeicherspannungsinformationen des Geräts benötigt wird. Eine Spannungsanpassung der Ladespannung erfolgt daher lediglich bei Ladezustandsübergängen, beispielsweise von Tiefentladung (ODBR) zu Schnellladung (FAST), von Schnellladung (FAST) zu Normalladung (NORM) und von Normalladung (NORM) zu Ladeschluss (TERM). Diese Übergänge sind mit deutlichen Änderungen der Ladestromstärke verbunden, so dass eine einfache, zuverlässige und betriebssichere Erfassung der Ladezustandsübergänge ermöglicht ist.

Die stufenweise variierende Ladespannung ist eine vereinfachte Form der bekannten kontinuierlichen Spannungsvariation, bei welcher die Ladespannung lediglich bei einer signifikanten Änderung des Ladestroms angepasst wird. Diese Änderungen im Stromfluss zum Laderegler des elektronischen Geräts lösen die Bestimmung des Ladezustands aus und regeln die Ladespannung des Ladegeräts.

Das erfindungsgemäße Ladegerät ist zum Laden eines wiederaufladbaren Energiespeichers eines elektronischen Geräts vorgesehen sowie dafür geeignet und eingerichtet. Das beispielsweise tragbar ausgeführte Ladegerät weist beispielsweise eine Energiequelle in Form eines integrierten Ladeenergiespeichers und/oder einer Energieschnittstelle (Stromanschluss, Netzteil, etc.) zur Bereitstellung einer elektrischen Ladeenergie auf, mittels welcher der Energiespeicher des elektronischen Geräts während eines Ladevorgangs aufgeladen wird. Die Energiequelle kann hierbei beispielsweise ein Akkumulator, beispielsweise eine Powerbank, sein, also ein elektrisches Gerät, das eine Ladeenergie zur Verfügung stellen kann (bspw. auch ein Laptop oder dergleichen, welcher über einen USB-Anschluss auch andere elektrische Geräte mit Energie versorgen kann). Das Ladegerät kann auch ein portables (wiederaufladbares) Batteriemodul sein.

Das Ladegerät weist weiterhin eine mit dem elektronischen Gerät koppelbare Ladeschnittstelle zur Energieübertragung auf. Das Ladegerät weist weiterhin einen mit der Ladeschnittstelle gekoppelten Leistungswandler (Umrichter, Spannungswandler) auf. Der Leistungswandler ist zwischen der Ladeschnittstelle und der Ladeenergiequelle (Ladeenergiespeicher, Energieschnittstelle, ...) verschaltet, und erzeugt im Ladebetrieb anhand der Ladeenergie eine Ladespannung für einen Ladevorgang.

Das Ladegerät weist weiterhin einen Stromsensor zur Erfassung eines Ladestroms während eines Ladevorgangs auf. Insbesondere weist das Ladegerät eine Spannungs-Strom-Erfassung, also einen Spannungs-Strom-Sensor, auf, um den Ladestrom sowie die Ladespannung an der Ladeschnittstelle und die Ausgangsspannung am Leistungswandler zu überwachen.

Die Spannungs-Strom-Erfassung sowie der Leistungswandler sind mit einem Controller (das heißt einer Steuereinheit) gekoppelt. Dadurch ist ein besonders geeignetes Ladegerät realisiert. Der Spannungssensor wird hierbei zur Überwachung der Ladespannung und zur Rückmeldung der Informationen an den Controller des Ladegeräts verwendet, wobei der Controller insbesondere zur Regelung der Ladespannung und der Ausgangsspannung des Leistungswandlers verwendet wird.

Der Controller ist hierbei allgemein - programm- und/oder schaltungstechnisch - zur Durchführung des vorstehend beschriebenen erfindungsgemäßen Verfahrens eingerichtet. Der Controller ist somit konkret dazu eingerichtet zu Beginn eines Ladevorgangs eine konstante nominale Ladespannung des Leistungswandlers einzustellen, und anschließend während des Ladevorgangs anhand einer erfassten Stromstärke des Ladestroms einen aktuellen Ladezustand des geräteseitigen Energiespeichers sowie ein dafür geeignetes Spannungsniveau zu bestimmen und die Ladespannung auf dieses Spannungsniveau einzustellen.

In einer bevorzugten Ausgestaltungsform ist der Controller zumindest im Kern durch einen Mikrocontroller mit einem Prozessor und einem Datenspeicher gebildet, in dem die Funktionalität zur Durchführung des erfindungsgemäßen Verfahrens in Form einer Betriebssoftware (Firmware) programmtechnisch implementiert ist, so dass das Verfahren - gegebenenfalls in Interaktion mit einem Vorrichtungsnutzer - bei Ausführung der Betriebssoftware in dem Mikrocontroller automatisch durchgeführt wird. Der Controller kann im Rahmen der Erfindung alternativ aber auch durch ein nicht-programmierbares elektronisches Bauteil, wie zum Beispiel einem anwendungsspezifischen integrierten Schaltkreis (ASIC) oder durch einem FPGA (Field Programmable Gate Array), gebildet sein, in dem die Funktionalität zur Durchführung des erfindungsgemäßen Verfahrens mit schaltungstechnischen Mitteln implementiert ist. Weiterhin ist eine schaltungs- oder hardwaretechnische Implementierung des Controllers mittels Fensterkomparatoren denkbar.

Die gemessenen Spannungs- und Stromstärkeniveaus werden in den des Controllers eingespeist, um den sich ändernden Ladezustand zu bestimmen und zu verarbeiten. Diese Verarbeitung bildet vorzugsweise eine vollständige Rückkopplungsschleife, bei welcher der aktuelle Ladezustand bestimmt und die Ausgangsspannung des Leistungswandlers angepasst wird. Die Anpassung der Ausgangsspannung des Leistungswandlers wird in einer vorteilhaften Ausführung durch Variation eines veränderbaren Ausgangssignals des Controllers gesteuert und/oder geregelt. Mit anderen Worten generiert der Controller ein Ausgangssignal für den Leistungswandler, um dessen Ausgangsspannung anzupassen und zu regeln sowie die Ladespannung so zu ändern, dass sie dem für den aktuellen Ladezustand geeigneten Spannungsniveau entspricht.

Die Anpassung oder Änderung des Ausgangssignals wird beispielsweise durch eine Pulsweitenmodulation (PWM) oder durch eine Digital-Analog-Wandlung (DAC) realisiert. Änderungen dieser Ausgangssignale verändern die Ausgangsspannung des Leistungswandlers, wodurch wiederum die an der Ladeschnittstelle und den Eingang des Geräts gelieferte Ladespannung angepasst wird.

In einer bevorzugten Ausgestaltung ist die vom Leistungswandler erzeugte Ladespannung durch eine Regelschleife geregelt. Dadurch ist eine zuverlässige und betriebssichere Variierung der Ausgangsspannung ermöglicht. Insbesondere ist ein geschlossenes Regelkreissystem für den Leistungswandler vorgesehen. Der Leistungswandler weist hierbei entweder ein externes, geregeltes System auf oder ist als ein IC-basierter Leistungswandler mit einem integrierten, geregelten System ausgeführt.

Das erfindungsgemäße Ladesystem weist ein vorstehend beschriebenes Ladegerät sowie ein elektronisches Gerät mit einem aufladbaren Energiespeicher auf. Dadurch ist ein besonders geeignetes Ladesystem realisiert. Insbesondere ist ein zuverlässiges und effizientes Laden des Energiespeichers ohne zusätzliche Kommunikationsverbindung zwischen dem Ladegerät und dem Gerät ermöglicht.

In einer zweckmäßigen Ausgestaltung weist das elektronische Gerät hierbei eine (Geräte-)Ladeschnittstelle zur Kopplung mit dem Ladegerät und ein zwischen der Ladeschnittstelle und dem Energiespeicher gekoppelten Laderegler auf.

Vorzugsweise ist das elektronische Gerät ein Hörinstrument oder Hörgerät, insbesondere ein Hörhilfegerät.

Nachfolgend sind Ausführungsbeispiele der Erfindung anhand einer Zeichnung näher erläutert. Darin zeigen:
- Fig. 1: in schematischer Darstellung ein Ladesystem mit einem Ladegerät und mit einem elektronischen Gerät,
- Fig. 2: ein Spannungs-Strom-Zeit-Diagramm für einen Ladevorgang des Ladesystems,
- Fig. 3: ein Flussdiagramm für ein Verfahren zur Durchführung des Ladevorgangs,
- Fig. 4: in schematischer Darstellung einen Stromsensor des Ladegeräts,
- Fig. 5: in schematischer Darstellung einen Spannungssensor des Ladegeräts,
- Fig. 6 bis Fig. 11: in schematischen Darstellungen verschiedene Ausführungsbeispiele für einen Leistungswandler des Ladegeräts,
- Fig. 12: in schematischer Darstellung eine Regelschleife zur Regelung einer Ausgangsspannung des Leistungswandlers,
- Fig. 13, Fig. 14: in schematischer Darstellung zwei Ausführungsbeispiele für einen schalterbasierten Leistungswandler mit integriertem Schaltkreis,
- Fig. 15: in schematischer Darstellung ein schalterbasierten Leistungswandler mit integriertem Schaltkreis,
- Fig. 16: in schematischer Darstellung ein Fensterkomparator,
- Fig. 17: ein Flussdiagramm für ein hardwaretechnisch implementiertes Verfahren zur Durchführung des Ladevorgangs,
- Fig. 18: ein Spannungs-Strom-Zeit-Diagramm für einen Ladevorgang mit konstanter Ladespannung, und
- Fig. 19: ein Spannungs-Strom-Zeit-Diagramm für einen Ladevorgang mit schrittweise angepasster Ladespannung,
- Fig. 20: ein Leistungs-Zeit-Diagramm für einen Ladevorgang mit konstanter Ladespannung und für einen Ladevorgang mit schrittweise angepasster Ladespannung, und
- Fig. 21: ein Effizienz-Zeit-Diagramm für einen Ladevorgang mit konstanter Ladespannung und für einen Ladevorgang mit schrittweise angepasster Ladespannung.

Einander entsprechende Teile und Größen sind in allen Figuren stets mit den gleichen Bezugszeichen versehen.

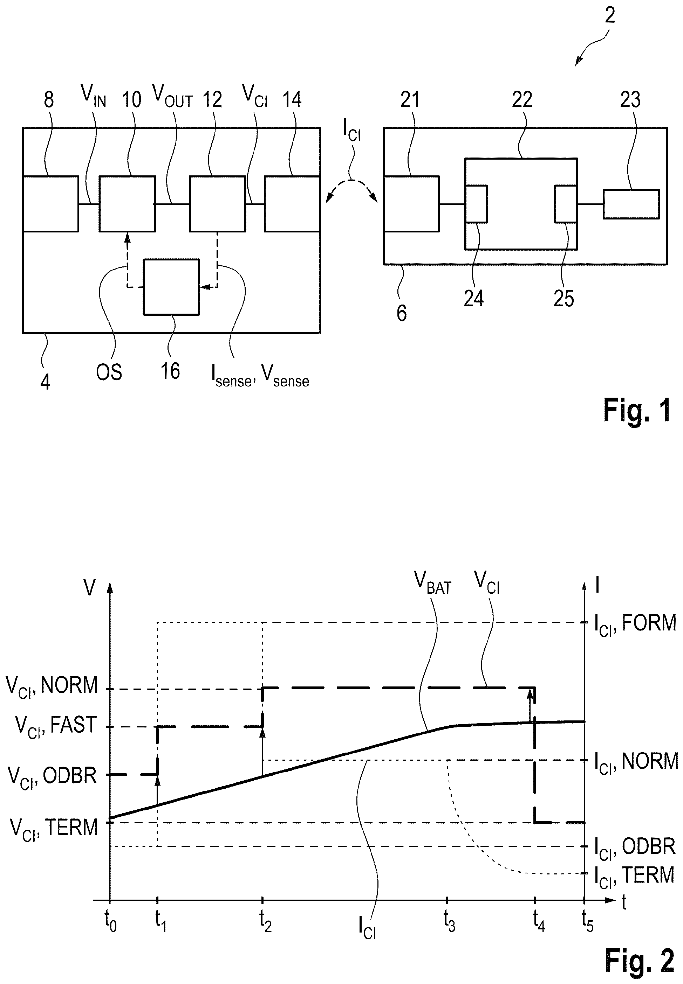

Die Fig. 1 zeigt in schematischer und vereinfachter Darstellung ein Ladesystem 2 mit einem Ladegerät 4 und mit einem elektronischen Gerät 6. Das Ladesystem 2 ist hierbei ohne eine Kommunikationsverbindung beziehungsweise ohne ein Kommunikationsprotokoll zwischen dem Ladegerät 4 und dem elektronischen Gerät 6 ausgeführt.

Das Ladegerät 4 weist eine Energiequelle 8, einen Leistungswandler 10 zur Bereitstellung einer Ladespannung V_{CI}, einen Strom-Spannungs-Sensor (VI-Sensor) 12, eine Ladeschnittstelle 14 und einen Controller 16 auf.

Die Energiequelle 8 stellt die elektrische Energie für einen Ladevorgang des Ladegeräts 4 bereit, und ist beispielsweise als ein in das Ladegerät 4 integrierter Energiespeicher und/oder als eine Energieschnittstelle, insbesondere als ein Netzanschluss (Netzteil, Stromanschluss), ausgeführt.

Der Leistungswandler 10 wandelt eine Eingangsspannung V_{IN} der Energiequelle 8 in eine Ausgangsspannung V_{OUT}, welche als Ladespannung V_{CI} an die Ladeschnittstelle 14 angelegt wird. Der Leistungswandler 10 ist insbesondere ein Umrichter oder Spannungswandler.

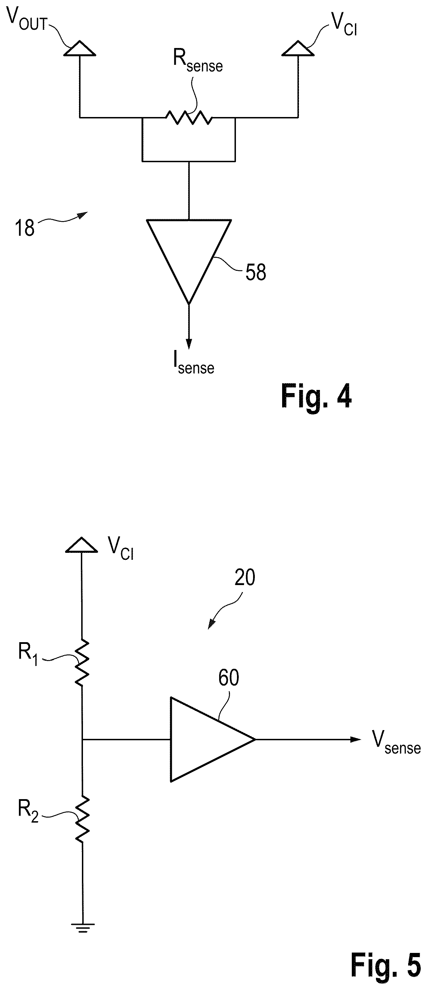

Der Strom-Spannungs-Sensor 12 ist als ein kombinierter Stromsensor 18 (Fig. 4) und Spannungssensor 20 (Fig. 5) ausgeführt. In einem Ladebetrieb des Ladegeräts 4, bei welchem das Gerät 6 aufgeladen wird, überwacht der Strom-Spannungs-Sensor 12 einen Ladestrom I_{CI} sowie die Ladespannung V_{CI} an der Ladeschnittstelle 14 und die Ausgangsspannung V_{OUT}. Der Spannungssensor 20 wird hierbei während des Ladebetriebs insbesondere zur Überwachung der Ladespannung V_{CI} verwendet, um diese auf einem gewünschten Spannungsniveau zu halten, wobei der Stromsensor 18 kontinuierlich den Ladestrom I_{CI} überwacht.

Die Ladeschnittstelle 14 ist insbesondere als ein Ladekontakt oder Ladeanschluss (Ladekontaktanschluss) ausgeführt, welcher während eines Ladevorgangs mit einer (Geräte-)Ladeschnittstelle 21 des elektronischen Geräts 6 galvanisch gekoppelt ist. Die Ladeschnittstellen 14, 21 sind hierbei beispielsweise für eine Steckverbindung als Stecker-Buchsen-Paar ausgeführt.

Das elektronische Gerät 6 weist die Ladeschnittstelle 21, einen Laderegler 22 und einen durch das Ladegerät 4 wiederaufladbaren Energiespeicher 23 auf. Der Laderegler 22 weist einen mit der Ladeschnittstelle 21 verbundenen Ladeeingang 24 und einen mit dem Energiespeicher 23 verbundenes Batterieterminal 25 auf. Der Energiespeicher 23 ist insbesondere als ein Akkumulator, vorzugsweise als eine Lithium-Ionen-Batterie, ausgeführt. Das elektronische Gerät 6 ist insbesondere als ein Hörinstrument, vorzugsweise als ein Hörhilfegerät, ausgeführt, wobei eine Batteriespannung V_{BAT} des Energiespeichers 23 im Betrieb des elektronischen Geräts 6 beispielsweise zwischen 3,0 V und 4,2 V dimensioniert ist.

Der Controller 16 ist signaltechnisch mit dem Strom-Spannungs-Sensor 12 und mit dem Leistungswandler 10 gekoppelt. Während eines Ladebetriebs sendet der Strom-Spannungs-Sensor 12 ein Maß für die gemessenen Stromstärke Iₛₑₙₛₑ des Ladestroms I_{CI} sowie ein Maß für das gemessene Spannungsniveau Vₛₑₙₛₑ der Ladespannung V_{CI} an den Controller 16. Anhand der empfangenen Sensordaten erzeugt der Controller 16 ein Ausgangssignal OS zur Steuerung und/oder Regelung des Leistungswandlers 10 beziehungsweise zur Steuerung und/oder Regelung der Ausgangsspannung V_{OUT}.

Aufgrund eines gewissen Stromverbrauchs im Laderegler 24 ist der über die Ladeschnittstellen 14, 21 fließende Ladestrom I_{CI} etwas höher dimensioniert als der mit dem jeweiligen Ladezustand verbundene Ladestrom. Diese Beziehung ist in der nachfolgenden Gleichung veranschaulicht ${I}_{CI} = {I}_{BAT} + {I}_{OC}$ wobei I_{BAT} den zum Energiespeicher 23 fließenden Ladestrom und loc den vom Laderegler 24 verwendeten Stromverbrauch bezeichnet.

Der Controller 16 stellt zu Beginn eines Ladevorgangs eine konstante nominale Ladespannung V_{CI} beziehungsweise eine konstante nominale Ausgangsspannung V_{OUT} des Leistungswandlers 10 ein. Das Spannungsniveau der dieser anfänglichen Ladespannung V_{CI} ist hierbei derart dimensioniert, dass der Laderegler 24 des elektronischen Geräts 6 seine Arbeit aufnimmt. Mit anderen Worten ist der resultierende Ladestrom I_{CI} größer oder gleich dem Stromverbrauch loc des Ladereglers 24 dimensioniert.

Während des Ladevorgangs wird der durch die Ladeschnittstelle 14 fließende elektrische Ladestrom I_{CI} mittels des Stromsensors 18 erfasst und an den Controller 16 gesendet. Die Stromstärke des Ladestroms I_{CI} ist abhängig von einem Ladezustand des geräteseitigen Energiespeichers 23, so dass die gemessene Stromstärke Iₛₑₙₛₑ zur Bestimmung eines aktuellen Ladezustands verwendet werden kann. Der Controller 16 ist hierbei dazu vorgesehen und eingerichtet anhand der gemessenen Stromstärke Iₛₑₙₛₑ den aktuellen Ladezustand zu bestimmen, und ein Ausgangssignal OS zur Anpassung der Ladespannung V_{CI} beziehungsweise der Ausgangsspannung V_{OUT} zu erzeugen, so dass ein für den aktuellen Ladezustand geeigneten Spannungsniveau bereitgestellt wird.

Hierzu sind beispielsweise vier Ladezustände des Energiespeichers 23 anhand von im Controller 16 hinterlegten oder schaltungstechnisch implementierten Stromschwellwerten oder Stromschwellwertbereichen hinterlegt.

In diesem Ausführungsbeispiel sind beispielsweise vier Ladezustände für den Energiespeicher definiert und hinterlegt. Die Ladezustände sind hierbei beispielsweise "Überentladungs-Wiederherstellungsladung" (ODBR), "Schnellladung" (FAST), "Normalladung" (NORM) und "Ladevorgang beenden" (TERM). Der FAST-Ladezustand weist hierbei den höchsten Ladestrom I_{CI}, _{FAST} der vier Ladezustände auf. Darauf folgt der Ladestrom I_{CI}, _{NORM} des NORM-Ladezustands, wobei der ODBR-Ladezustand den nächsthöheren Ladestrom I_{CI}, _{ODBR} aufweist. Der TERM-Ladezustand weist den niedrigsten Ladestrom I_{CI}, _{TERM} auf. Im Ladebetrieb wird der erfasste Ladestrom Iₛₑₙₛₑ mit den Ladestromwerten für die Ladezustände verglichen, und in Abhängigkeit davon eine jeweils geeignete Ladespannung V_{CI}, _{FAST}, V_{CI}, _{NORM}, V_{CI}, _{ODBR}, V_{CI}, _{TERM} eingestellt.

Vorzugsweise wird die Ladespannung V_{CI} stufenweise als Reaktion auf signifikante Schwankungen der erfassten Stromstärke Iₛₑₙₛₑ hin geändert, ohne dass Informationen des Ladezustands von dem Gerät 6 an das Ladegerät 4 übermittelt werden. Eine Spannungsanpassung der Ladespannung V_{CI} erfolgt vorzugsweise lediglich bei Ladezustandsübergängen, beispielsweise von Tiefentladung (ODBR) zu Schnellladung (FAST), von Schnellladung (FAST) zu Normalladung (NORM) und von Normalladung (NORM) zu Ladeschluss (TERM). Diese Übergänge sind mit deutlichen Änderungen der Ladestromstärke Iₛₑₙₛₑ verbunden, so dass eine einfache, zuverlässige und betriebssichere Erfassung der Ladezustandsübergänge ermöglicht ist.

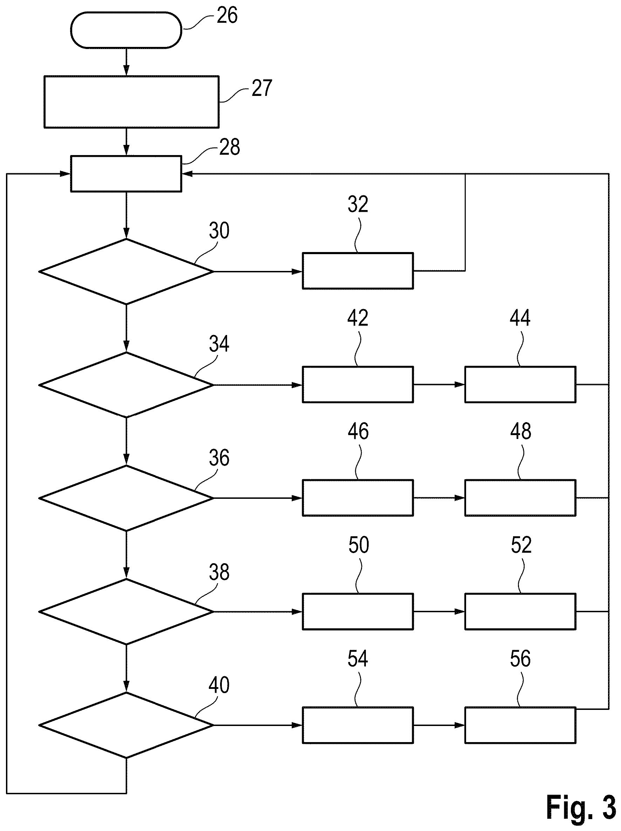

Das Ladeverfahren beziehungsweise die stufenweise variierende Ladespannung V_{CI} ist nachfolgend anhand der Figuren 2 und 3 näher erläutert.

Die Fig. 2 zeigt in einem kombinierten Zeit-Spannungs- und Zeit-Strom-Diagramm schematisch ein Ladeprofil für einen Ladevorgang, bei welchem der Energiespeicher 23 aus einem tiefentladenen Ladezustand auf ein im Wesentlichen vollgeladenen Ladezustand aufgeladen wird. In der Fig. 2 ist horizontal, also entlang der Abszissenachse (X-Achse), die Zeit t, und entlang der vertikalen Ordinatenachse (Y-Achse) einerseits eine Spannung V (linke Achse) sowie andererseits eine Stromstärke I (rechte Achse) aufgetragen. Der zeitliche Verlauf der Batteriespannung V_{BAT} ist mit einer durchgezogenen Linie dargestellt, wobei der zeitliche Verlauf des Ladestroms I_{CI} punktiert und der zeitliche Verlauf der Ladespannung V_{CI} strichliniert gezeigt ist.

Zum Zeitraum t0 bis t1 liegt ein ODBR-Ladezustand, im Zeitraum t1 bis t2 ein FAST-Ladezustand, im Zeitraum t2 bis t4 ein NORM-Ladezustand und im Zeitraum t4 bis t5 liegt ein TERM-Ladezustand vor.

Der ODBR-Ladezustand tritt auf, wenn die Batteriespannung V_{BAT} unter einem normalen Betriebsbereich, beispielsweise unter 3,0 V, liegt. Der ODBR-Ladezustand realisiert hierbei eine Wiederherstellung nach einer Tiefentladung des Energiespeichers.

Der FAST-Ladezustand tritt auf, wenn die Batteriespannung V_{BAT} innerhalb eines normalen Betriebsbereichs, aber nahe einem unteren Ende liegt, beispielsweise zwischen 3,0 V und 3,9 V.

Der NORM-Ladezustand ist durch eine Batteriespannung V_{BAT} charakterisiert, welche höher als der Schwellwert für das Schnellladen ist. Der NORM-Bereich ist beispielsweise zwischen 3,7 V und 4,35 V dimensioniert.

Der TERM-Ladezustand "Ladevorgang beenden" ist erreicht, wenn die Energiespeicherspannung nahezu der vollen Ladespezifikation entspricht, beispielsweise wischen 4,2 V und 4,35 V. In der Fig. 2 ist der Energiespeicher 23 beispielsweise zum Zeitpunkt t3 nahezu vollständig geladen, so dass der Ladestrom I_{CI} abnimmt und der TERM-Ladezustand gestartet wird.

Die Fig. 3 zeigt ein Flussdiagramm für das Ladeverfahren. Zur besseren Erläuterung des Verfahrens ist die erfasste Stromstärke Iₛₑₙₛₑ nachfolgend auch als Ladestrom I_{CI} zu einem bestimmten Zeitpunkt t mit der Notation I_{CI}, t bezeichnet. Der Controller 16 ist hierbei insbesondere als ein Mikrocontroller (MCU) ausgeführt.

Zur Durchführung des Ladeverfahrens werden die Ladeschnittstellen 14 und 21 miteinander verbunden, und das Verfahren mit einem Verfahrensschritt 26 gestartet.

In einem darauffolgenden Verfahrensschritt 27 wird die Ladespannung V_{CI} auf eine konstante nominale Ladespannung beziehungsweise auf ein konstantes nominales Spannungsniveau gesetzt. Beispielsweise wird der Ladestrom I_{CI}, ₀ hierbei auf null (I_{CI,0} = 0) gesetzt. Das Spannungsniveau ist derart gewählt, dass der Laderegler 22 aktiviert wird.

Während des Verfahrens wird in einem Verfahrensschritt 28 die Stromstärke Iₛₑₙₛₑ des Ladestroms I_{CI} durch den Strom-Spannungs-Sensor 12 erfasst, so dass der Ladestrom I_{CI} zu dem jeweiligen Zeitpunkt t dem Controller 16 zur Auswertung zur Verfügung steht.

Der Controller 16 vergleicht in einem ersten Schwellwertvergleich 30 den aktuell gemessenen Ladestrom I_{CI}, t mit dem vorher gemessenen Ladestrom I_{CI,t-1} zum Zeitpunkt t-1 unter Berücksichtigung eines Toleranzbereichs. Mit anderen Worten wird geprüft, ob der aktuell gemessene Ladestrom I_{CI,t} größer als die Differenz zwischen dem vorhergehend gemessenen Ladestrom I_{CI,t-1} und einem Toleranzwert Iₜₒₗ ist, und ob der aktuell gemessene Ladestrom I_{CI,t} kleiner als die Summe zwischen dem vorhergehend gemessenen Ladestrom I_{CI,t-1} und dem Toleranzwert Iₜₒₗ ist. Der Schwellwertvergleich 30 ist somit durch folgende Formel gegeben: ${I}_{CI , t - 1} - {I}_{tol} \leq {I}_{CI , t} \leq {I}_{CI , t - 1} + {I}_{tol}$

Bei einem positiven Vergleichsergebnis ist der Ladestrom I_{CI} im Wesentlichen konstant geblieben, wobei in einem Verfahrensschritt 32 der vorhergehende Wert mit dem aktuellen Messwert überschrieben wird (I_{CI, t-1} = I_{CI}, t).

Bei einem positiven Vergleichsergebnis, liegt eine hinreichend große Änderung der Ladestromstärke vor, mit anderen Worten hat sich der Ladestrom I_{CI, t} im Vergleich zum Ladestrom I_{CI}, ₜ₋₁ wesentlich verändert. Dies bedeutet, dass sich der Ladezustand des Energiespeichers 32 signifikant verändert hat. In diesem Fall wird der aktuelle Ladestrom I_{CI, t} mit den hinterlegten Schwellwerten für die Ladezustände ODBR, FAST, NORM und TERM verglichen, jeweils unter Berücksichtigung eines Toleranzbereichs beziehungsweise des Toleranzwerts Iₜₒₗ. Hierzu werden vier Schwellwertvergleiche 34, 36, 38, 40 durchgeführt. Die Schwellwertvergleiche werden beispielsweise parallel oder nacheinander ausgeführt, zum Beispiel gestaffelt nach Höhe der jeweiligen Ladeströme (TERM, ODBR, NORM, FAST), oder wie in der Fig. 3 gezeigt nach einem erwarteten zeitlichen Ablauf für einen Ladevorgang, bei welchem der Energiespeicher 23 aus einem tiefentladenen Ladezustand auf ein im Wesentlichen vollgeladenen Ladezustand aufgeladen wird.

Der Controller 16 vergleicht in dem Schwellwertvergleich 34 den aktuell gemessenen Ladestrom I_{CI, t} mit dem Schwellwert für den ODBR-Ladestrom I_{CI}, _{ODBR} unter Berücksichtigung eines Toleranzbereichs. Mit anderen Worten wird geprüft, ob der aktuell gemessene Ladestrom I_{CI,t} größer als die Differenz zwischen dem Schwellwert für den ODBR-Ladestrom I_{CI}, _{ODBR} und einem Toleranzwert Iₜₒₗ ist, und ob der aktuell gemessene Ladestrom I_{CI,t} kleiner als die Summe zwischen dem Schwellwert für den ODBR-Ladestrom I_{CI}, _{ODBR} und dem Toleranzwert Iₜₒₗ ist. Der Schwellwertvergleich 34 ist somit durch folgende Formel gegeben: ${I}_{CI , ODBR} - {I}_{tol} \leq {I}_{CI , t} \leq {I}_{CI , ODBR} + {I}_{tol}$

Bei einem positiven Vergleichsergebnis, also wenn der aktuell gemessene Ladestrom I_{CI}, ₜ im Wesentlichen dem Schwellwert für den ODBR-Ladestrom I_{CI, ODBR} entspricht, wird von dem Controller 16 in einem Verfahrensschritt 42 ein Ausgangssignal OS_{ODBR} erzeugt (OS = OS_{ODBR}) und an den Leistungswandler 10 gesendet. Der Leistungswandler 10 regelt anschließend in einem Verfahrensschritt 44 die Ladespannung V_{CI} auf die geeignete Ladespannung V_{CI}, _{ODBR} für den "Überentladungs-Wiederherstellungsladung"-Ladezustand (V_{CI} = V_{CI}, _{ODBR}). Anschließend wird der resultierende Ladestrom im Verfahrensschritt 28 gemessen.

Bei einem negativen Vergleichsergebnis, also wenn der aktuell gemessene Ladestrom I_{CI}, ₜ nicht im Toleranzbereich des ODBR-Ladestroms I_{CI}, _{ODBR} liegt, wird der Schwellwertvergleich 36 durchgeführt.

Der Controller 16 vergleicht in dem Schwellwertvergleich 36 den aktuell gemessenen Ladestrom I_{CI, t} mit dem Schwellwert für den FAST-Ladestrom I_{CI}, _{FAST} unter Berücksichtigung eines Toleranzbereichs. Mit anderen Worten wird geprüft, ob der aktuell gemessene Ladestrom I_{CI,t} größer als die Differenz zwischen dem Schwellwert für den FAST-Ladestrom I_{CI}, _{FAST} und einem Toleranzwert Iₜₒₗ ist, und ob der aktuell gemessene Ladestrom I_{CI,t} kleiner als die Summe zwischen dem Schwellwert für den FAST-Ladestrom I_{CI}, _{FAST} und dem Toleranzwert Iₜₒₗ ist. Der Schwellwertvergleich 36 ist somit durch folgende Formel gegeben: ${I}_{CI , FAST} - {I}_{tol} \leq {I}_{CI , t} \leq {I}_{CI , FAST} + {I}_{tol}$

Bei einem positiven Vergleichsergebnis, also wenn der aktuell gemessene Ladestrom I_{CI}, t im Wesentlichen dem Schwellwert für den FAST-Ladestrom I_{CI}, _{FAST} entspricht, wird von dem Controller 16 in einem Verfahrensschritt 46 ein Ausgangssignal OS_{FAST} erzeugt (OS = OS_{FAST}) und an den Leistungswandler 10 gesendet. Der Leistungswandler 10 regelt anschließend in einem Verfahrensschritt 48 die Ladespannung V_{CI} auf die geeignete Ladespannung V_{CI}, _{FAST} für den "Schnellladung"-Ladezustand (V_{CI} = V_{CI}, _{FAST}). Anschließend wird der resultierende Ladestrom im Verfahrensschritt 28 gemessen.

Bei einem negativen Vergleichsergebnis, also wenn der aktuell gemessene Ladestrom I_{CI}, t nicht im Toleranzbereich des FAST-Ladestroms I_{CI}, _{FAST} liegt, wird der Schwellwertvergleich 38 durchgeführt.

Der Controller 16 vergleicht in dem Schwellwertvergleich 38 den aktuell gemessenen Ladestrom I_{CI}, t mit dem Schwellwert für den NORM-Ladestrom I_{CI}, _{NORM} unter Berücksichtigung eines Toleranzbereichs. Mit anderen Worten wird geprüft, ob der aktuell gemessene Ladestrom I_{CI,t} größer als die Differenz zwischen dem Schwellwert für den NORM-Ladestrom I_{CI}, _{NORM} und einem Toleranzwert Iₜₒₗ ist, und ob der aktuell gemessene Ladestrom I_{CI,t} kleiner als die Summe zwischen dem Schwellwert für den NORM-Ladestrom I_{CI}, _{NORM} und dem Toleranzwert Iₜₒₗ ist. Der Schwellwertvergleich 38 ist somit durch folgende Formel gegeben: ${I}_{CI , NORM} - {I}_{tol} \leq {I}_{CI , t} \leq {I}_{CI , NORM} + {I}_{tol}$

Bei einem positiven Vergleichsergebnis, also wenn der aktuell gemessene Ladestrom I_{CI}, ₜ im Wesentlichen dem Schwellwert für den NORM-Ladestrom I_{CI}, _{NORM} entspricht, wird von dem Controller 16 in einem Verfahrensschritt 50 ein Ausgangssignal OS_{NORM} erzeugt (OS = OS_{NORM}) und an den Leistungswandler 10 gesendet. Der Leistungswandler 10 regelt anschließend in einem Verfahrensschritt 52 die Ladespannung V_{CI} auf die geeignete Ladespannung V_{CI}, _{NORM} für den "Normalladung"-Ladezustand (V_{CI} = V_{CI}, _{NORM}). Anschließend wird der resultierende Ladestrom im Verfahrensschritt 28 gemessen.

Bei einem negativen Vergleichsergebnis, also wenn der aktuell gemessene Ladestrom I_{CI}, t nicht im Toleranzbereich des NORM-Ladestroms I_{CI}, _{NORM} liegt, wird der Schwellwertvergleich 40 durchgeführt.

Der Controller 16 vergleicht in dem Schwellwertvergleich 40 den aktuell gemessenen Ladestrom I_{CI, t} mit dem Schwellwert für den TERM-Ladestrom I_{CI}, _{TERM} unter Berücksichtigung eines Toleranzbereichs. Mit anderen Worten wird geprüft, ob der aktuell gemessene Ladestrom I_{CI,t} größer als die Differenz zwischen dem Schwellwert für den TERM-Ladestrom I_{CI}, _{TERM} und einem Toleranzwert Iₜₒₗ ist, und ob der aktuell gemessene Ladestrom I_{CI,t} kleiner als die Summe zwischen dem Schwellwert für den TERM-Ladestrom I_{CI}, _{TERM} und dem Toleranzwert Iₜₒₗ ist. Der Schwellwertvergleich 40 ist somit durch folgende Formel gegeben: ${I}_{CI , TERM} - {I}_{tol} \leq {I}_{CI , t} \leq {I}_{CI , TERM} + {I}_{tol}$

Bei einem positiven Vergleichsergebnis, also wenn der aktuell gemessene Ladestrom I_{CI}, ₜ im Wesentlichen dem Schwellwert für den TERM-Ladestrom I_{CI}, _{TERM} entspricht, wird von dem Controller 16 in einem Verfahrensschritt 54 ein Ausgangssignal OS_{TERM} erzeugt (OS = OS_{TERM}) und an den Leistungswandler 10 gesendet. Der Leistungswandler 10 regelt anschließend in einem Verfahrensschritt 56 die Ladespannung V_{CI} auf die geeignete Ladespannung V_{CI}, _{TERM} für den "Ladevorgang beenden"-Ladezustand (V_{CI} = V_{CI}, TERM). Anschließend wird der resultierende Ladestrom im Verfahrensschritt 28 gemessen.

Bei einem negativen Vergleichsergebnis, also wenn der aktuell gemessene Ladestrom I_{CI,t} nicht im Toleranzbereich des TERM-Ladestroms I_{CI}, _{TERM} liegt, befindet sich der Ladestrom I_{CI}, ₜ im Wesentlichen außerhalb der Toleranzbereiche der hinterlegten Ladezustände ODBR, FAST, NORM, TERM, und es wird der Verfahrensschritt 28 gestartet.

Durch die Toleranzbereiche bei den Schwellwertvergleichen 34, 36, 38, 40 wird die Ladespannung V_{CI} stufen- oder schrittweise eingestellt, wenn eine Änderung des Ladezustands, also ein Übergang zwischen zwei definierten oder hinterlegten Ladezuständen, beziehungsweise zwischen zwei hinterlegten Schwellwert(-bereichen), erfasst wird. Bei einer solchen stufenweisen Änderung erfolgen Spannungsanpassungen lediglich bei Ladezustandsübergängen und bleiben ansonsten konstant (Fig. 2).

Die Fig. 4 zeigt eine Ausführung des Stromsensors 18, welcher mit einem Reihenwiderstand Rₛₑₙₛₑ in Verbindung mit einer Verstärkerschaltung 58 realisiert. Der Eingang des Verstärkers 58 wird vom Spannungsabfall über dem Reihenwiderstand Rₛₑₙₛₑ abgeleitet, der eine Potentialdifferenz erzeugt, wenn Strom durch ihn fließt. Der Verstärker 58 verstärkt diesen Spannungsabfall dann auf ein höheres Niveau und sendet das Ausgangssignal als Strommesspegel Iₛₑₙₛₑ im Spannungsbereich an einen Analog-Digital-Wandler (ADC)-Eingang des Controllers 16. Der Controller 16 verwendet hierbei beispielsweise einen Algorithmus, um den ADC-Spannungseingang in eine digitale Darstellung des tatsächlichen Ladestroms I_{CI} umzuwandeln. Der Reihenwiderstand Rₛₑₙₛₑ wird so gewählt, dass er möglichst einen niedrigen Widerstandswert aufweist, um Leistungsverluste und Spannungsabfälle zu minimieren und dadurch die Ausgangsspannung V_{OUT} des Leistungswandlers 10 nahe an der Ladespannung V_{CI} der Ladeschnittstelle 14 zu halten. Vorzugsweise weist der Reihenwiderstand Rₛₑₙₛₑ einen Wert von weniger als 1 Ω (Ohm) auf. Vorzugsweise wird hierbei ein Verstärker 58 mit möglichst hoher Verstärkung verwendet, um den geringen Widerstand des Reihenwiderstands Rₛₑₙₛₑ auszugleichen und die Auflösung des erfassten Strompegels zu verbessern, der für den ADC des Controllers 16 geeignet ist. Zweckmäßigerweise wird die Verstärkerschaltung 58 unter Verwendung eines Differenzoperationsverstärkers mit einem Verstärkungswert von mehr als 10 implementiert.

Der in Fig. 5 gezeigte Spannungssensor 10 wird beispielsweise mithilfe eines Spannungsteilers realisiert, der an eine Verstärkerschaltung 60 angeschlossen ist. Der Eingang des Verstärkers 60 ist mit dem Ausgang des Spannungsteilers verbunden, welcher sich zwischen zwei Widerständen R₁, R₂ befindet. Der Spannungsteiler senkt die Spannung an der Ladeschnittstelle 14 auf ein niedrigeres Spannungsniveau ab. Der Verstärker 60 folgt dann diesem Eingangsspannungsniveau und gibt es an einen entsprechenden ADC-Port des Controllers 16 als Spannungsmesspegel Vₛₑₙₛₑ aus. Der Controller 16 wandelt diesen Spannungsmesswert Vₛₑₙₛₑ in einen digitalen Wert um, welcher die an der Ladeschnittstelle 14 gemessenen tatsächlichen Ladespannung V_{CI} für die weitere Verarbeitung widerspiegelt. Der Spannungsteiler reduziert die Ladespannung V_{CI} der Ladeschnittstelle 14 des Ladegeräts 4 auf ein Spannungsniveau, das für den ADC-Eingangsbereich des Controllers 16 geeignet ist. Vorzugsweise werden für beide Widerstände R₁, R₂ im Spannungsteiler hohe Widerstandswerte gewählt, um den Stromfluss durch die Spannungsteilerschaltung während der Spannungsmessung zu minimieren. Die Verstärkerschaltung 60 ist beispielsweise mit einem Spannungsfolger realisierbar, welcher am Eingang und Ausgang das gleiche Spannungsniveau beibehält, während er einen vernachlässigbaren Strom vom und zum ADC-Eingang des Controllers 16 zieht.

Die gemessenen Spannungs- und Stromstärkeniveaus Iₛₑₙₛₑ, Vₛₑₙₛₑ werden in den ADC-Port des Controllers 16 eingespeist, um den sich ändernden Ladezustand zu bestimmen und zu verarbeiten. Diese Verarbeitung bildet vorzugsweise eine vollständige Rückkopplungsschleife, bei welcher der aktuelle Ladezustand bestimmt und die Ausgangsspannung V_{OUT} des Leistungswandlers 10 angepasst wird. Die Anpassung der Ausgangsspannung V_{OUT} des Leistungswandlers 10 wird durch Variation des Ausgangssignals OS des Controllers 16 gesteuert und/oder geregelt. Mit anderen Worten generiert der Controller 16 ein Ausgangssignal OS für den Leistungswandler 10, um dessen Ausgangsspannung V_{OUT} anzupassen und zu regeln sowie die Ladespannung V_{CI} so zu ändern, dass sie dem für den aktuellen Ladezustand geeigneten Spannungsniveau entspricht.

Die Anpassung oder Änderung des Ausgangssignals OS wird beispielsweise durch eine Pulsweitenmodulation (PWM) oder durch eine Digital-Analog-Wandlung (DAC) realisiert. Änderungen dieser Ausgangssignale OS verändern die Ausgangsspannung V_{OUT} des Leistungswandlers 10, wodurch wiederum die an der Ladeschnittstelle 14 und den Eingang des Geräts 6 gelieferte Ladespannung V_{CI} angepasst wird.

In der in Fig. 1 gezeigten Hardware-Implementierung ist der Leistungswandler 10 für die Anpassung der Ladespannung V_{CI} durch Umwandlung der Ausgangsspannung V_{OUT} von entscheidender Bedeutung. Das Ladegerät 4 weist beispielsweise eine Energiequelle 8 in Form eines USB-Anschlusses auf, welche eine konstante Eingangsspannung V_{IN} von 5 V bereitstellt, während der Betriebsspannungsbereich für Lithium-Ionen-Batterien normalerweise zwischen 3,0 V und 4,2 V liegt. Daher kann der Leistungswandler 10, der eine gemeinsame Masse zwischen Eingang und Ausgang aufrechterhält verschiedene Topologien aufweisen.

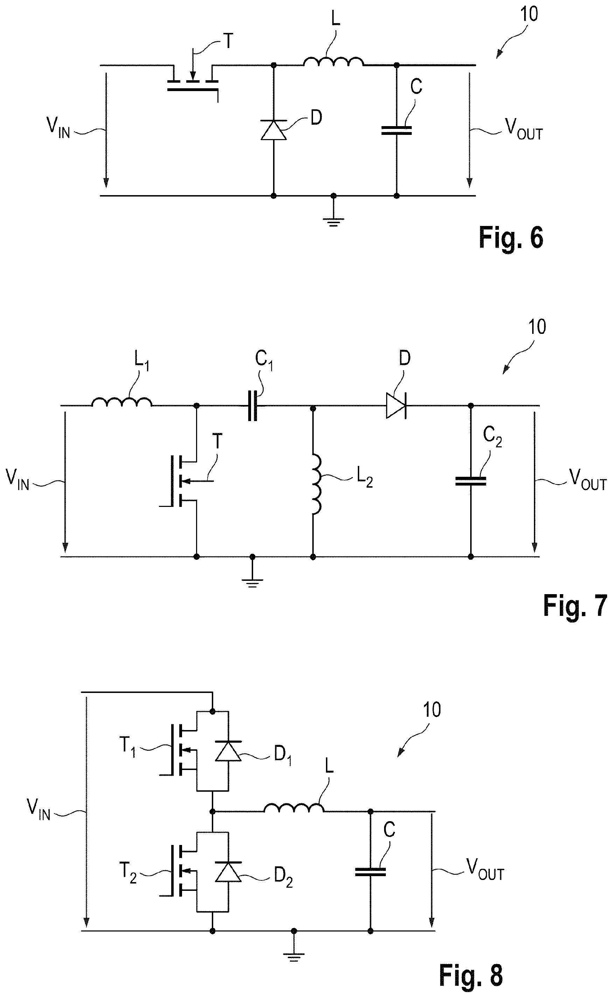

Fig. 6 zeigt eine Ausführung des Leistungswandlers 10 als Abwärtswandler (buck converter). Der Leistungswandler 10 weist einen Transistor T, eine Induktivität L, eine (Freilauf-)Diode D und einen (Ausgangs-)Kondensator C auf, welche in einer dem Fachmann geläufigen Abwärtswandlerschaltung verschaltet sind. Der Abwärtswandler ist so konzipiert, dass er die Ausgangsspannung V_{OUT} im Vergleich zur Eingangsspannung V_{IN} reduziert.

Die Fig. 7 zeigt eine Ausführung des Leistungswandlers 10 als SEPIC-Wandler (SEPIC-converter), welcher die Ausgangsspannung V_{OUT} im Vergleich zur Eingangsspannung V_{IN} entweder erhöhen oder verringern kann. Sowohl Abwärts- als auch SEPIC-Wandler haben eine gemeinsame Masse zwischen ihren Eingangs- und Ausgangsanschlüssen.

Der Leistungswandler 10 weist hierbei zwei Induktivitäten L₁, L₂, einen Transistor T, zwei Kondensatoren C₁, C₂ und eine Diode D auf, welche in einer dem Fachmann geläufigen SEPIC-Wandlerschaltung verschaltet sind.

Fig. 8 zeigt einen als Halbbrücken-Abwärtswandler (half-bridge buck conveter) ausgeführten Leistungswandler 10, aufweisend zwei Transistoren T₁, T₂ mit Body-Dioden D₁, D₂, einer Induktivität L und einem Kondensator C.

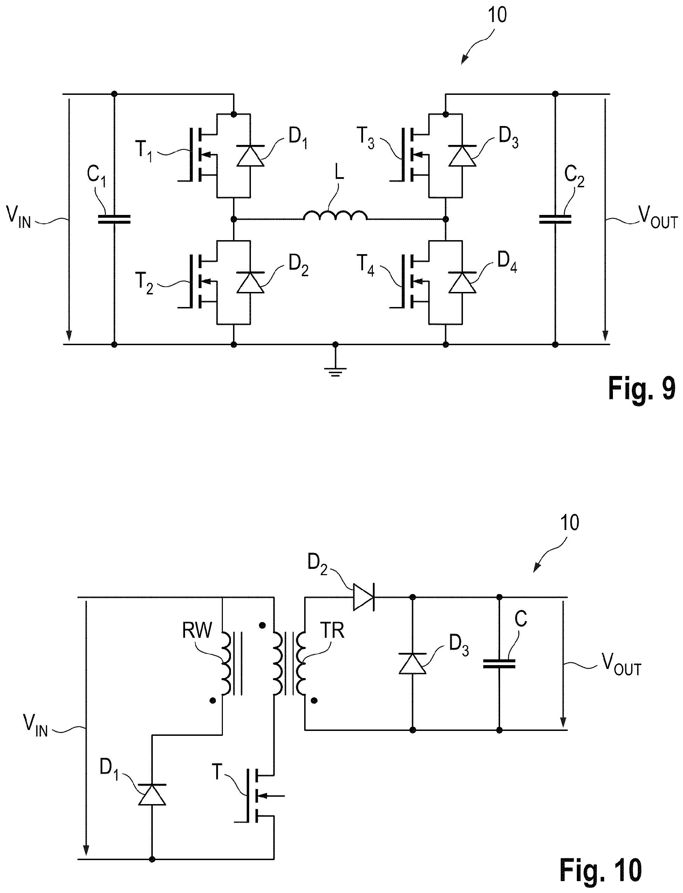

In der Fig. 9 ist eine Ausführung des Leistungswandlers 10 als kaskadierter Abwärts-Aufwärtswandler (cascaded buck-boost converter), aufweisend vier als zwei Brückenzweige verschaltete Transistoren T₁, T₂, T₃, T₄ mit Body-Dioden D₁, D₂, D₃, D₄ einer zwischen den Brückenzweigen verschalteten Induktivität L und jeweils einem der Brückenzweige parallel geschalteten Kondensator C₁, C₂.

Die Fig. 10 zeigt einen als Durchflusswandler (forward converter) ausgeführten Leistungswandler 10 für eine transformatorbasierte Strom-/Spannungswandlung. Der Leistungswandler 10 weist hierbei drei Dioden D₁, D₂, D₃, einen Transistor T, einen Transformator TR mit Rückwicklung RW und einen Kondensator C auf.

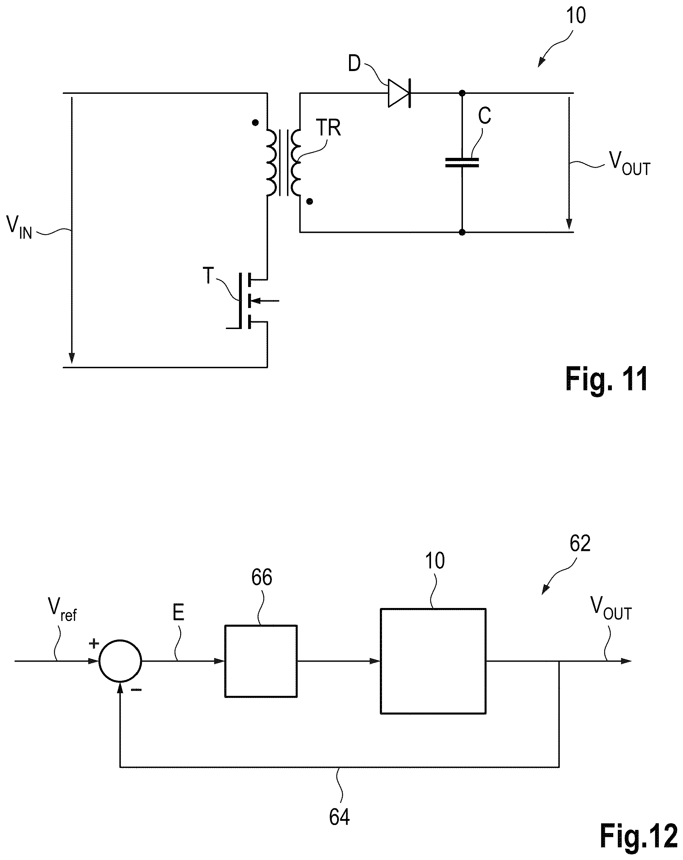

Die Fig. 11 zeigt einen als Sperrwandler (flyback converter) ausgeführten Leistungswandler 10 welcher ebenfalls für eine transformatorbasierte Strom-/Spannungswandlung ausgeführt ist. Der Leistungswandler 10 weist hierbei eine Diode D, einen Transistor T, einen Transformator TR und einen Kondensator C auf.

Zur Variierung der Ausgangsspannung V_{OUT} ist ein geschlossenes Regekreissystem 62 vorgesehen. Das in Fig. 12 gezeigte Regelkreissystem 62 weist eine Rücckopplungsschleife als Regelschleife 64 auf, welche die Ausgangsspannung V_{OUT} zum Vergleich mit einer Referenzspannung V_{ref} zurückgibt. Die Referenzspannung V_{ref} entspricht hierbei der jeweils vorgesehenen Ladespannung V_{CI}, _{FAST}, V_{CI}, _{NORM}, V_{CI}, _{ODBR}, V_{CI}, _{TERM} für einen jeweils aktuellen Ladezustand (FAST, NORM, ODBR, TERM), welche durch das Ausgangssignal OS des Controllers 16 eingestellt oder ausgewählt wird.

Eine Differenz zwischen der Ausgangsspannung V_{OUT} und der Referenzspannung V_{ref} erzeugt ein Fehlersignal E. Dieses Fehlersignal E wird beispielsweise in einen PID-Regler (Proportional-Integral-Differential) 66 eingespeist, welcher den Ausgang kontinuierlich anpasst, um Abweichungen zwischen der Ausgangsspannung V_{OUT} und der eingestellten Referenzspannung V_{ref} zu korrigieren. Der PID-Regler 66 erzeugt ein Tastverhältnis, indem er das Fehlersignal E mit einer periodischen Wellenform, z. B. einer Sägezahnwelle, vergleicht. Dieses Tastverhältnis wird beispielsweise als Pulsweitenmodulationssignal (PWM) dargestellt. Das PWM-Signal wird dann von einem Schalttreiber verstärkt, um die Schalter des Leistungswandlers 10 zu steuern und sie ein- und auszuschalten. Wenn sich das PWM-Signal ändert, werden der Induktor und der Kondensator im Leistungswandler 10 geladen und entladen, wodurch die Ausgangsspannung V_{OUT} an die Referenzspannung V_{ref} angepasst wird.

Das gesamte geschlossene Regelkreissystem 62, mit Ausnahme des Leistungswandlers 10, ist beispielsweise auch in den Controller 16 implementierbar. Die Ausgangsspannung V_{OUT} aus der Regelschleife 64 wird über den Spannungs-sensor 20 an einen ADC des Controllers 16 gesendet. Der Controller 16 erzeugt ein PWM-Signal als Ausgangssignal OS, um den Schalter des Leistungswandlers 10 anzusteuern, und erzeugt in Verbindung mit einem externen Schalttreiber ein periodisches Tastverhältnis, um den Leistungswandler 10 zu regeln. Die Referenzspannungen V_{ref} sind die Spannungsniveaus V_{CI}, _{FAST}, V_{CI}, _{NORM}, V_{CI}, _{ODBR}, V_{CI}, _{TERM} für jeden Ladezustand (FAST, NORM, ODBR, TERM), und sind hierbei digital in einem Speicher des Controllers 16 hinterlegt oder voreingestellt, und werden basierend auf dem erfassten Ladestrom I_{CI} angepasst.

Alternativ ist auch ein Hardware-Ansatz zur Implementierung eines geschlossenen Regelkreises möglich. Die Referenzspannung V_{ref} kann durch einen Spannungsteiler oder eine Schaltung mit niedriger Dropout-Spannung (Low Drop Out, LDO) bereitgestellt werden. Das Fehlersignal E wird insbesondere durch eine Differenzverstärkerschaltung erzeugt, welche die Referenzspannung V_{ref} mit der Ausgangsspannung V_{OUT} des Leistungswandlers 10 vergleicht. Das Tastverhältnis wird beispielsweise durch einen Komparator erreicht, welcher die Eingabe von einer periodischen Wellenform und die Ausgabe eines PID-Verstärkers erhält. Der PID-Verstärker weist eine parallel geschaltete Proportionalverstärkerschaltung, eine Integralverstärkerschaltung und eine Differenzverstärkerschaltung auf. Der PID-Verstärker verarbeitet das Fehlersignal E, welches die Ausgabe des Differenzverstärkers ist. Das resultierende Tastverhältnis-Ausgangssignal wird dann an einen Schaltertreiber gesendet, welcher das Signal auf einen ausreichenden Leistungspegel verstärkt, um die Schalter im Leistungswandler 10 zu steuern und sie ein- und auszuschalten.

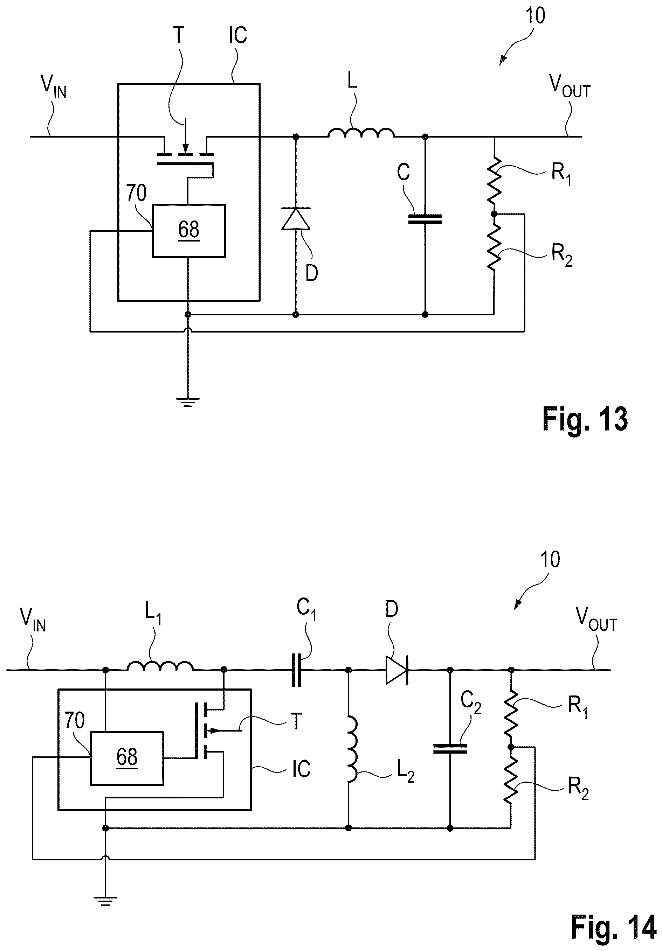

Das geschlossene Regelsystem kann auch mit einem integrierten Schaltkreis (IC) mit schaltungsbasiertem Leistungswandler (switch-based power converter) realisiert werden, beispielsweise als ein in Fig. 13 gezeigter IC schaltungsbasierter Abwärtswandler (switch-based buck converter) oder als ein in Fig. 14 gezeigter IC schaltungsbasierter SEPIC-Wandler (switch-based SEPIC converter). Die Regelung ist in einen Rückkopplungssteuerblock (feedback control) 68 des integrierten Schaltkreises IC integriert, welcher Funktionen wie Komparator, PID-Regler, PWM-Generator, Schalttreiber, Softstart-Referenz, Stromsensor, Überstromschutz und Oszillator umfasst. Der integrierte Schaltkreis IC enthält einen Schalter oder Transistor T, welcher von einem PWM-Generator und -Treiber innerhalb des Rückkopplungssteuerblocks 68 gesteuert wird.

Ein Rückkopplungspin 70 des integrierten Schaltkreises IC wird zur Regulierung der Ausgangsspannung V_{OUT} verwendet, um sicherzustellen, dass sie dem vorgegebenen Sollwert bzw. der Referenzspannung V_{ref} entspricht. Die Ausgangsspannung V_{OUT} wird durch das Verhältnis zweier in Reihe geschalteter und parallel zum Ausgang des Leistungswandlers 10 angeordneter Widerstände R₁, R₂ eingestellt. Die Beziehung zwischen der Ausgangsspannung Vₒᵤₜ den Widerständen R₁, R₂ und der Referenzspannung V_{ref} wird durch folgende Gleichung beschrieben, welcher von einem Spannungsteiler abgeleitet ist: ${V}_{out} = \left(\frac{R 1}{R 2}+1\right) \times {V}_{ref} .$

Der integrierte Schaltkreis IC mit schaltungsbasiertem Leistungswandler weist in der in Fig. 13 gezeigten Ausführung weiterhin eine Diode D, eine Induktivität L und einen Kondensator C auf, wobei in der Fig. 14 gezeigten Variante eine Diode D, zwei Induktivitäten L₁, L₂ und zwei Kondensatoren C₁, C₂ vorgesehen sind.

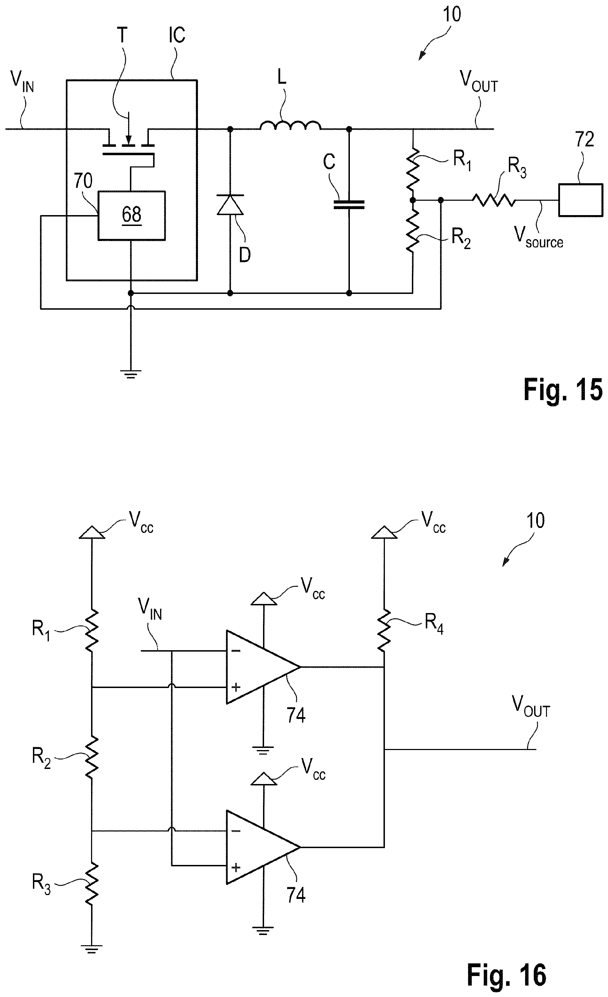

Um die Ausgangsspannung V_{OUT} eines IC-Schalter-basierten Leistungswandlers 10 anzupassen, wird ein zusätzlicher Schaltkreis bestehend aus einer Spannungsquelle 72 und einem Reihenwiderstand R₃ eingeführt (Fig. 15). Der Ausgang dieser Spannungsquelle 72 mit Reihenwiderstand R₃ ist mit dem Ausgang des Spannungsteilers verbunden und wird in den Rückkopplungspin 70 eingespeist. Die Variation der Ausgangsspannung V_{OUT} wird durch Änderung eines Spannungsniveaus/-pegels V_{source} der Spannungsquelle 72 erreicht. Diese Anpassung kann durch Modifizierung des Pulsweitenmodulationssignals (PWM) von dem Controller 16 in Verbindung mit einem Tiefpassfilter erreicht werden. Alternativ kann der Pegel V_{source} der Spannungsquelle 72 durch Anpassen der Ausgangsspannung eines Digital-Analog-Wandlers (DAC) innerhalb des Controllers 16 variiert werden. Fig. 15 veranschaulicht den Aufbau der Spannungsquelle 72 und des Reihenwiderstands R₃ zur Erzielung einer variablen Ausgangsspannung V_{OUT} am Beispiel eines auf einem IC schaltungsbasierter Abwärtswandler (Fig. 13). Die Einstellung der Ausgangsspannung V_{OUT} für den auf einem integrierten Schaltkreis IC basierenden Leistungswandler 10 erfolgt durch Änderung des Spannungsniveaus V_{source}, und die Beziehung zwischen der Ausgangsspannung V_{OUT} und des Spannungsniveaus V_{source} wird durch, die aus einer Knotenpunktanalyse abgeleiteten, Gleichung: ${V}_{out} = \left(\frac{{R}_{2} {R}_{3} + {R}_{1} {R}_{3} + {R}_{1} {R}_{2}}{{R}_{2} {R}_{3}}\right) {V}_{ref} - \left(\frac{{R}_{1}}{{R}_{3}}\right) {V}_{source}$ bestimmt.

Zusätzlich zu den in Fig. 1 und Fig. 3 gezeigten Algorithmusansätzen zur Variation der Ausgangsspannung V_{OUT} von IC-Schalter-basierten Leistungswandlern 10 besteht eine alternative Lösung in der Verwendung einer Fensterkomparatorschaltung, wie in Fig. 16 dargestellt. Der Fensterkomparator funktioniert, indem er die Ausgangsspannung V_{OUT} hochzieht, wenn sich sowohl der obere als auch der untere Komparator 74 im hohen Zustand befinden. Wenn sich entweder der obere oder der untere Komparator 74 (oder beide) im niedrigen Zustand befinden, wird V_{OUT} auf niedrig gezogen. Die Werte der Widerstände R₁, R₂ und R₃ bestimmen den Eingangsspannungsbereich für den Fensterkomparator, der zu einer hohen Ausgangsspannung V_{OUT} führt. Die Beziehung zwischen der Ausgangsspannung, der Eingangsspannung V_{IN}, den Widerständen R₁, R₂, R₃ und einer Versorgungsspannung Vcc der Komparatoren 74 wird folgende Gleichung beschrieben: ${V}_{out} = \left\{\begin{matrix}{V}_{cc} : & \frac{{R}_{3}}{{R}_{1} + {R}_{2} + {R}_{3}} \leq {V}_{in} \leq \frac{{R}_{2} + {R}_{3}}{{R}_{1} + {R}_{2} + {R}_{3}} \\ 0 : & {V}_{in} < \frac{{R}_{3}}{{R}_{1} + {R}_{2} + {R}_{3}} or {V}_{in} > \frac{{R}_{2} + {R}_{3}}{{R}_{1} + {R}_{2} + {R}_{3}}\end{matrix}\right.$

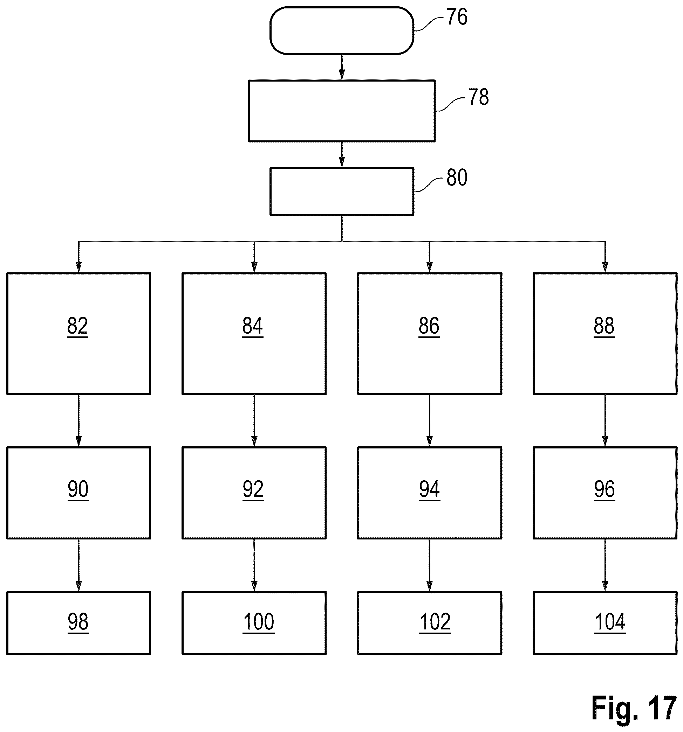

Die Fig. 17 veranschaulicht den Hardware-Ansatz zur Implementierung einer stufenweise variierenden Ladespannung V_{CI}, wodurch eine ähnliche Funktion wie beim Controller-Algorithmus-Ansatz erreicht wird. In einem ersten Verfahrensschritt.

In einem Verfahrensschritt 76 wird das Ladeverfahren gestartet. Zunächst wird in einem Verfahrensschritt 78 eine konstante nominale Ladespannung V_{CI} an der Ladeschnittstelle 14 angelegt, um sicherzustellen, dass der Ladevorgang korrekt beginnt.

In einem anschließenden Verfahrensschritt 80 wird der Ladestrom I_{CI} gemessen. Der Stromfluss wird beispielsweise mit dem in Fig. 4 gezeigten Stromsensor 18 gemessen, in einen Spannungspegel umgewandelt und in einem Verfahrensschritt 82, 84, 86, 88 als Eingangsspannung V_{IN} in einen Fensterkomparators eingespeist. Insbesondere sind hierbei vier Fensterkomparatoren vorgesehen, jeweils einer pro vorgesehenen Ladezustand (ODBR, FAST, NORM, TERM).

Wenn der Spannungspegel in eines der vier voreingestellten Spannungsfenster (FAST, ODBR, NORM, TERM) fällt, wird der Ausgang des jeweils zugeordneten Fensterkomparators hochgezogen. Dieser hohe Ausgang aktiviert in einem jeweiligen Verfahrensschritt 90, 92, 94, 96 eine Spannungsquelle für den IC-Schalterbasierten Leistungswandler 10 oder liefert eine jeweilige Referenzspannung V_{ref} (V_{CI}, _{FAST}, V_{CI}, _{NORM}, V_{CI}, _{ODBR}, V_{CI}, _{TERM}) für das geschlossene System des Hardware-Ansatzes. Diese Spannungsquelle stammt in der Regel von einem LDO-Schaltkreis oder einem Spannungsteilerschaltkreis. Schließlich passt der Leistungswandler 10 in einem jeweiligen Verfahrensschritt 98, 100, 102, 104 seine Ausgangsspannung V_{OUT} an, die mit der Ladeschnittstelle 14 verbunden ist, um die stufenweise variierende Ladeeingangsspannung V_{CI} zu erreichen.

Für den ODBR-Ladezustand werden die Verfahrensschritte 82, 90 und 98 (V_{CI} = V_{CI,ODBR}), für den FAST-Ladezustand die Verfahrensschritte 84, 92 und 100 (V_{CI} = V_{CI,FAST}), für den NORM-Ladezustand die Verfahrensschritte 86, 94 und 102 (V_{CI} = V_{CI,NORM}), und für den TERM-Ladezustand die Verfahrensschritte 88, 96 und 104 (V_{CI} = V_{CI}, _{TERM}) ausgeführt.

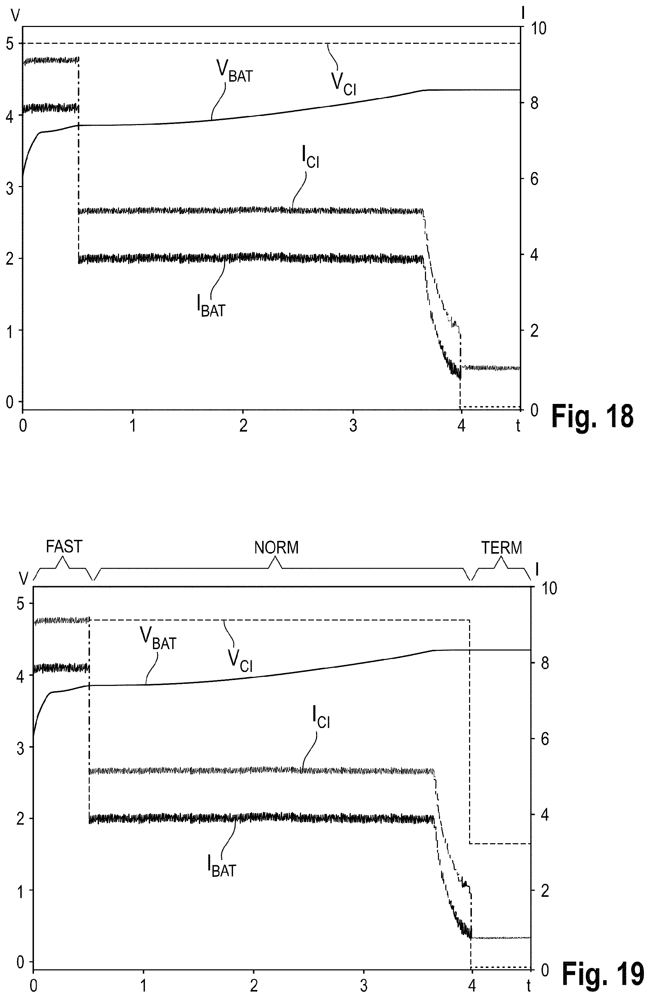

Nachfolgend ist anhand der Figuren 18 bis 21 ein experimenteller Vergleich für eine vollständige Aufladung des Energiespeichers 23 gezeigt, bei welchem ein herkömmlicher Ansatz mit konstanter Ladespannung V_{CI} mit dem erfindungsgemäßen Verfahren mit stufenweise variierender Ladespannung V_{CI} verglichen wird.

Die Figuren 18 und 19 zeigen in einem kombinierten Zeit-Spannungs- und Zeit-Strom-Diagramm jeweils schematisch ein Ladeprofil für einen Ladevorgang, bei welchem der Energiespeicher 23 aus einem tiefentladenen Ladezustand mit einer konstanten Ladespannung V_{CI} (Fig. 18) und mit einer schrittweise variierenden Ladespannung V_{CI} (Fig. 19) auf ein im Wesentlichen vollgeladenen Ladezustand aufgeladen wird. In der Fig. 18 und Fig. 19 ist horizontal, also entlang der Abszissenachse (X-Achse), die Zeit t in Stunden (h), und entlang der vertikalen Ordinatenachse (Y-Achse) einerseits eine Spannung V in Volt (V) (linke Achse) sowie andererseits eine Stromstärke I in Milliampere (mA) (rechte Achse) aufgetragen.

Der zeitliche Verlauf der Batteriespannung V_{BAT} ist mit einer durchgezogenen Linie dargestellt, wobei der zeitliche Verlauf der Ladespannung V_{CI} strichliniert gezeigt ist. Der zeitliche Verlauf des Ladestroms I_{CI} an der Ladeschnittstelle 14 ist strichpunktiert und der zeitliche Verlauf des von dem Laderegler 22 in den Energiespeicher 23 eingespeisten Batteriestroms I_{BAT} ist punktiert gezeigt.

Bei beiden Ladeverfahren wurde das gleiche Gerät 6 bei normalem Batteriebetrieb getestet, wobei die Batteriespannung V_{BAT} zwischen 3,0 V und 4,2 V liegt. Die Fig. 18 zeigt das vollständige Ladeprofil für den Ansatz mit konstanter Ladespannung V_{CI}, während Fig. 19 das vollständige Ladeprofil für den Ansatz mit stufenweise variierender Ladespannung V_{CI} zeigt. Der Hauptunterschied zwischen den beiden Ladeverfahren besteht in der Ladespannung V_{CI}. Beim Ansatz mit stufenweiser Änderung der Ladespannung V_{CI} wird die Ladespannung V_{CI} je nach Modus oder Ladezustand (FAST, NORM, TERM) angepasst, während beim Ansatz mit konstanter Ladespannung V_{CI} während des gesamten Ladevorgangs eine feste Spannungsversorgung beibehalten wird.

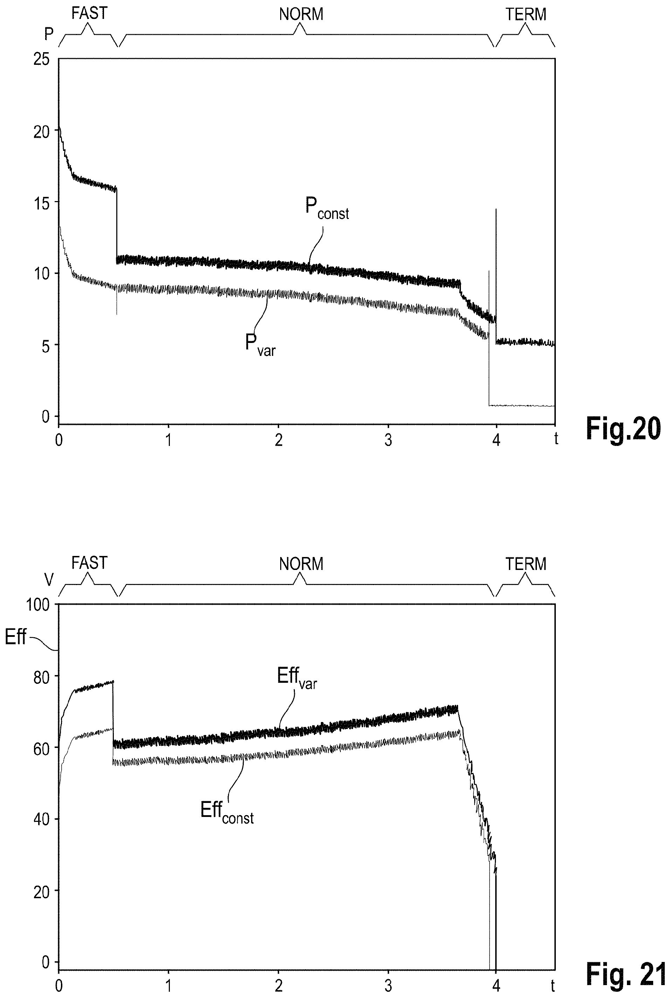

Die Fig. 20 zeigt ein Zeit-Leistungs-Diagramm für die Ladevorgänge. In der Fig. 20 ist horizontal, also entlang der Abszissenachse (X-Achse), die Zeit t in Stunden (h), und entlang der vertikalen Ordinatenachse (Y-Achse) ist die Leistungsaufnahme P in Milliwatt (mW) aufgetragen. Die Fig. 20 veranschaulicht die Leistungsprofile P_{const}, Pᵥₐᵣ sowohl für den Ansatz mit konstanter Ladespannung V_{CI} (P_{const}) als auch für den Ansatz mit stufenweise variierender Ladespannung V_{CI} (Pᵥₐᵣ). Wie in der Fig. 20 vergleichsweise deutlich ersichtlich ist, ist der durchschnittliche Leistungsverbrauch beim schnellen Ladevorgang (FAST) um ca. 6 mW und beim normalen Ladevorgang (NORM) um ca. 2 mW reduziert, wenn der Ansatz mit stufenweiser Änderung verwendet wird. Diese Reduzierung des Leistungsverbrauchs deutet darauf hin, dass die Verwendung des Ansatzes mit stufenweiser Änderung der Ladespannung V_{CI} ein kompakteres tragbares Ladegerät 6 und eine höhere Anzahl von Ladezyklen ermöglicht.

Die Fig. 21 zeigt ein Zeit-Effizienz-Diagramm für die Ladevorgänge. In der Fig. 21 ist horizontal, also entlang der Abszissenachse (X-Achse), die Zeit t in Stunden (h), und entlang der vertikalen Ordinatenachse (Y-Achse) ist die Effizienz Eff in Prozent (%) aufgetragen. Die Fig. 21 zeigt die (Lade-)Effizienzprofile Eff_{const}, Effᵥₐᵣ für den gesamten Ladevorgang, von der Energiequelle 8 bis zum Batterieterminal 25, und vergleicht den Ansatz mit konstanter Ladespannung am Eingang (Eff_{const}) mit dem Ansatz mit stufenweise variierender Ladespannung am Eingang (Effᵥₐᵣ). Der Ansatz mit stufenweiser Änderung zeigt eine allgemeine Verbesserung der Ladeeffizienz von etwa 10 % im Schnellladezustand (FAST) und etwa 5 % im normalen Ladezustand (NORM) im Vergleich zum Ansatz mit konstanter Ladespannung. Im Endladezustand (TERM) ist die Ladeeffizienz jedoch bei beiden Methoden ähnlich, da der Ladestrom I_{CI} zum Energiespeicher 23 sehr gering ist.

Die beanspruchte Erfindung ist nicht auf die vorstehend beschriebenen Ausführungsbeispiele beschränkt. Vielmehr können auch andere Varianten der Erfindung von dem Fachmann hieraus im Rahmen der offenbarten Ansprüche abgeleitet werden, ohne den Gegenstand der beanspruchten Erfindung zu verlassen. Insbesondere sind ferner alle im Zusammenhang mit den verschiedenen Ausführungsbeispielen beschriebenen Einzelmerkmale im Rahmen der offenbarten Ansprüche auch auf andere Weise kombinierbar, ohne den Gegenstand der beanspruchten Erfindung zu verlassen.

### Bezugszeichenliste

- 2: Ladesystem
- 4: Ladegerät
- 6: Gerät
- 8: Energiequelle
- 10: Leistungswandler
- 12: Strom-Spannungs-Sensor
- 14: Ladeschnittstelle
- 16: Controller
- 18: Stromsensor
- 20: Spannungssensor
- 21: Ladeschnittstelle
- 22: Laderegler
- 23: Energiespeicher
- 24: Ladeeingang
- 25: Batterieterminal
- 26, 27, 28: Verfahrensschritt
- 30: Schwellwertvergleich
- 32: Verfahrensschritt
- 34, ..., 40: Schwellwertvergleich
- 42, ..., 56: Verfahrensschritt
- 58: Verstärkerschaltung
- 60: Verstärkerschaltung
- 62: Regelkreissystem
- 64: Regelschleife, Rückkopplungsschleife
- 66: PID-Regler
- 68: Rückkopplungssteuerblock
- 70: Rückkopplungspin
- 72: Spannungsquelle
- 74: Komparator
- 76, ..., 104: Verfahrensschritt
- V_{CI}: Ladespannung
- FAST, ODBR, TERM, NORM: Ladezustand
- V_{CI}, _{FAST}, V_{CI}, _{NORM}, V_{CI}, _{ODBR}, V_{CI}, _{TERM}: Ladespannung
- V_{IN}: Eingangsspannung
- V_{OUT}: Ausgangsspannung
- I_{CI}: Ladestrom
- I_{CI}, _{FAST}, I_{CI}, _{NORM}, I_{CI}, _{ODBR}, I_{CI}, _{TERM}: Ladestrom
- V_{BAT}: Batteriespannung
- I_{BAT}: Batteriestrom
- Iₛₑₙₛₑ: Stromstärke
- Vₛₑₙₛₑ: Spannungsniveau
- V: Spannung
- I: Stromstärke
- t: Zeit
- Rₛₑₙₛₑ: Reihenwiderstand
- R₁, R₂: Widerstand
- T, T₁, T₂: Transistor
- L, L₁, L₂: Induktivität
- D, D₁, D₂, D₃: Diode
- C, C₁, C₂: Kondensator
- t₀, t₁, t₂, t₃, t₄, t₅: Zeitpunkt
- TR: Transformator
- RW: Rückwicklung
- V_{ref}: Referenzspannung
- E: Fehlersignal
- V_{source}: Spannungsniveau
- P: Leistungsaufnahme
- Pconst, Pvar: Leistungsprofil
- Eff: Effizienz
- Eff_{const}, Effᵥₐᵣ: Effizienzprofil

## Patentansprüche

1. Verfahren zum Laden eines wiederaufladbaren Energiespeichers (23) eines elektronischen Geräts (6) über eine Ladeschnittstelle (14),
- wobei zu Beginn eines Ladevorgangs eine hinterlegte Ladespannung (V_{CI}) an die Ladeschnittstelle (14) angelegt wird,
- wobei während eines Ladevorgangs ein durch die Ladeschnittstelle (14) fließender Ladestrom (I_{CI}) erfasst wird,
- wobei anhand des erfassten Ladestroms (I_{CI}) ein aktueller Ladezustand (ODBR, FAST, NORM, TERM) des Energiespeichers (23) bestimmt wird,
- wobei für den bestimmten Ladezustand (ODBR, FAST, NORM, TERM) ein Spannungsniveau (V_{CI}, _{FAST}, V_{CI}, _{NORM}, V_{CI}, _{ODBR}, V_{CI}, _{TERM}) für die Ladespannung (V_{CI}) bestimmt wird, und
- wobei die Ladespannung (V_{CI}) auf das bestimmte Spannungsniveau (V_{CI}, _{FAST}, V_{CI}, _{NORM}, V_{CI}, _{ODBR}, V_{CI}, _{TERM}) eingestellt wird.

2. Verfahren nach Anspruch 1,
**dadurch gekennzeichnet,**
**dass** der aktuelle Ladezustand (ODBR, FAST, NORM, TERM) anhand eines Schwellwertvergleichs (34, 36, 38, 40) des erfassten Ladestroms (I_{CI}) mit einem hinterlegten Stromschwellwert (I_{CI}, _{FAST}, I_{CI}, _{NORM}, I_{CI}, _{ODBR}, I_{CI}, _{TERM}) bestimmt wird.

3. Verfahren nach Anspruch 1 oder 2,
**dadurch gekennzeichnet,**
**dass** eine Anzahl von Stromschwellwerte (I_{CI}, _{FAST}, I_{CI}, _{NORM}, I_{CI}, _{ODBR}, I_{CI}, _{TERM}) für unterschiedliche Ladezustände (FAST, NORM, ODBR, TERM) hinterlegt ist, wobei durch Vergleich des erfassten Ladestroms (I_{CI}) mit den Stromschwellwerten (I_{CI}, _{FAST}, I_{CI}, _{NORM}, I_{CI}, _{ODBR}, I_{CI}, _{TERM}) der aktuelle Ladezustand (FAST, NORM, ODBR, TERM) bestimmt wird.

4. Verfahren nach einem der Ansprüche 1 bis 3,
**dadurch gekennzeichnet,**
**dass** die Ladespannung (V_{CI}) bei einer Änderung des Ladezustands (FAST, NORM, ODBR, TERM) auf das bestimmte Spannungsniveau (V_{CI}, _{FAST}, V_{CI}, _{NORM}, V_{CI}, _{ODBR}, V_{CI}, _{TERM}) eingestellt wird.

5. Ladegerät (4) zum Laden eines wiederaufladbaren Energiespeichers (23) eines elektronischen Geräts (6), aufweisend
- eine mit dem elektronischen Gerät (6) koppelbare Ladeschnittstelle (14) zur Energieübertragung,
- einen mit der Ladeschnittstelle (14) gekoppelten Leistungswandler (10) zur Erzeugung einer Ladespannung (V_{CI}),
- einen Stromsensor (18) zur Erfassung eines Ladestroms (I_{CI}), und
- einen Controller (16) zur Durchführung eines Verfahrens nach einem der Ansprüche 1 bis 4.

6. Ladegerät (4) nach Anspruch 5,
**dadurch gekennzeichnet,**
**dass** der Controller (16) den Leistungswandler (10) mittels eines veränderbaren Ausgangssignals (OS) steuert und/oder regelt.

7. Ladegerät (4) nach Anspruch 5 oder 6,
**dadurch gekennzeichnet,**
**dass** die vom Leistungswandler (10) erzeugte Ladespannung (V_{CI}) durch eine Regelschleife (64) geregelt ist.

8. Ladesystem (2) aufweisend ein Ladegerät (4) nach einem der Ansprüche 5 bis 7 und ein elektronisches Gerät (6) mit einem aufladbaren Energiespeicher (23).

9. Ladesystem (2) nach Anspruch 8,
**dadurch gekennzeichnet,**
**dass** das elektronische Gerät (6) eine Ladeschnittstelle (21) zur Kopplung mit dem Ladegerät (6) und ein zwischen der Ladeschnittstelle (21) und dem Energiespeicher (23) gekoppelten Laderegler (22) aufweist.

10. Ladesystem (2) nach Anspruch 8 oder 9,
**dadurch gekennzeichnet,**
**dass** das elektronische Gerät (6) ein Hörgerät, insbesondere ein Hörhilfegerät, ist.
